# EUROPEAN PATENT APPLICATION

(11) **EP 4 818 848 A1**
(43) Date of publication of application: **07.10.2026**
(21) Application number: 25793219.4
(22) Date of filing: 24.02.2025
(51) Int. Cl.: G06F 1/16, H04M 1/02, H05K 5/03, F16C 11/04

(54) **MAIN SHAFT AND MANUFACTURING METHOD THEREFOR, ROTATING SHAFT MECHANISM, AND ELECTRONIC DEVICE**

(30) Priority: 24.04.2024 CN 202410502762
(71) Applicant: Honor Device Co., Ltd., Shenzhen, Guangdong 518040 (CN)
(72) Inventor: DONG, Shaohong, Shenzhen, Guangdong 518040 (CN); HUANG, Shengxian, Shenzhen, Guangdong 518040 (CN); ZHANG, Chunxiao, Shenzhen, Guangdong 518040 (CN); LI, Jianping, Shenzhen, Guangdong 518040 (CN); CHEN, Ruihao, Shenzhen, Guangdong 518040 (CN)
(74) Representative: Goddar, Heinz J.
(86) International application number: PCT/CN2025/078899
(87) International publication number: WO 2025/223021

(57) **Abstract**

This application provides a main shaft and a production method thereof, a rotary shaft mechanism, and an electronic device, and relates to the technical field of electronic products. The main shaft includes an upper shaft board and a lower shaft board that are connected to each other. The upper shaft board includes a plurality of upper brackets and a plurality of support portions. The upper brackets are arranged spaced away along a length direction of the upper shaft board. The support portions are connected between adjacent ones of the upper brackets. The lower shaft board includes a main board body and a plurality of lower brackets. The lower brackets are arranged spaced away along a length direction of the main board body, and are in one-to-one correspondence with the upper brackets. The plurality of upper brackets and the plurality of support portions are integrally formed, and the plurality of lower brackets and the main board body are integrally formed or integrally connected, so that the main shaft has a simple structure and good integrity, and structural strength and reliability of the main shaft can be improved, thereby facilitating lightening and thinning of the main shaft. In addition, assembly precision of the main shaft is high, so that moving precision of the rotary shaft mechanism can be improved, and a problem that a foldable screen arches can be improved. In addition, flatness of the main shaft is high, so that a light and shadow effect of the foldable screen can be improved

## Description

This application claims priority to Chinese Patent Application No. 202410502762.5, filed with the China National Intellectual Property Administration on April 24, 2024, and entitled "MAIN SHAFT AND PRODUCTION METHOD THEREOF, ROTARY SHAFT MECHANISM, AND ELECTRONIC DEVICE", which is incorporated herein by reference in its entirety.

### TECHNICAL FIELD

This application relates to the technical field of electronic products, and in particular, to a main shaft and a production method thereof, a rotary shaft mechanism, and an electronic device.

### BACKGROUND

A foldable screen is bendable, so that an electronic device carrying the foldable screen, that is, the electronic device, can be switched between an unfolded state and a folded state. The electronic device has a large display area, is convenient to be carried, and is increasingly favored by consumers.

A rotary shaft mechanism, as a core component of the electronic device, is used to implement relative rotation between two main body portions of the electronic device, and unfolding or folding of the foldable screen is implemented through the relative rotation between the two main body portions. As a main support structure of the rotary shaft mechanism, a main shaft determines basic strength of the entire rotary shaft mechanism. In addition, when a movable assembly (such as a primary swing arm, a secondary swing arm, or a damping swing arm) is unfolded or folded, a moving center of the movable assembly is located on the main shaft. Therefore, processing and assembling of the main shaft determine moving precision of the rotary shaft mechanism, and affect user experience.

However, a main shaft of an existing rotary shaft mechanism has a complex structure and low strength, and is difficult to be assembled. As a result, reliability of the main shaft is affected, and further lightening and thinning of the main shaft are limited.

### SUMMARY

This application provides a main shaft and a production method thereof, a rotary shaft mechanism, and an electronic device. The main shaft has a simple structure and high strength, and is easy to be assembled, so that reliability of the main shaft can be improved, thereby facilitating lightening and thinning of the main shaft.

According to a first aspect of this application, a main shaft is provided, including:
an upper shaft board, including a plurality of upper brackets and a plurality of support portions, where the plurality of upper brackets and the plurality of support portions are an integral structural member; and the upper brackets are arranged spaced away along a length direction of the upper shaft board, and the support portions are connected between adjacent ones of the upper brackets; and
a lower shaft board, connected to the upper shaft board, where the lower shaft board includes a main board body and a plurality of lower brackets, and the plurality of lower brackets and the main board body are an integral structural member; and the lower brackets are arranged spaced away along a length direction of the main board body, and the lower brackets are in one-to-one correspondence with the upper brackets.

The main shaft provided in this application includes the upper shaft board and the lower shaft board that are connected to each other. The upper shaft board includes the plurality of upper brackets and the plurality of support portions. The upper brackets are arranged spaced away along the length direction of the upper shaft board. The support portions are connected between the adjacent ones of the upper brackets. The lower shaft board includes the main board body and the plurality of lower brackets. The lower brackets are arranged spaced away along the length direction of the main board body, and are in one-to-one correspondence with the upper brackets. The lower brackets are all connected to the main board body. The plurality of upper brackets and the plurality of support portions are integrally formed, to form the integrated upper shaft board, and the plurality of lower brackets and the main board body are integrally formed or integrally connected, to form the integrated lower shaft board. The integrated upper shaft board and the integrated lower shaft board form the main shaft. In this way, the main shaft has a simple structure and good integrity, structural strength of the main shaft can be improved, and reliability of a rotary shaft mechanism is improved, thereby facilitating lightening and thinning of the main shaft. In addition, the main shaft is easy to be assembled, assembly precision is high, and precision of positioning each movable component is high, so that moving precision of the rotary shaft mechanism can be improved, and a problem that a foldable screen arches can be improved. In addition, flatness of the main shaft is high, so that a light and shadow effect of the foldable screen can be improved.

In a possible implementation, one of the lower bracket and the main board body is provided with a connection groove, and the other is provided with a connection protrusion. The connection protrusion extends into the connection groove, and the connection protrusion is integrally connected to the connection groove.

One of the lower bracket and the main board body is first formed, and the connection groove is provided on the first formed one. Then, the first formed one of the lower bracket and the main board body is used as a basic structure, the other of the lower bracket and the main board body is formed on the first formed one, and a material of the later formed one enters the connection groove to form the connection protrusion, so as to integrally form the lower brackets and the main board body into the lower shaft board. Through mutual fitting of the connection protrusion and the connection groove, a contact area between the lower bracket and the main board body can be increased, and a shear force between the lower bracket and the main board body can be increased, to enhance integrity and reliability of the lower shaft board.

In a possible implementation, the connection groove is provided on the lower bracket. The connection groove includes a first groove segment and a second groove segment. The second groove segment is located on a side of the first groove segment that faces away from the main board body. A cross-sectional area of the second groove segment is larger than a cross-sectional area of the first groove segment.

The connection protrusion is provided on the main board body. The connection protrusion includes a connection portion and a limiting portion. The limiting portion is connected to an end of the connection portion that is far away from the main board body. The connection portion is integrally connected to the first groove segment, and the limiting portion is integrally connected to the second groove segment.

A step groove including the first groove segment and the second groove segment is formed on the lower bracket, so that the cross-sectional area of the first groove segment far away from the main board body is larger than the cross-sectional area of the first groove segment close to the main board body. Correspondingly, when the main board body is integrally formed on the lower bracket, the connection protrusion formed on the main board body may include the connection portion and the limiting portion. A cross-sectional area of the limiting portion connected to the end of the connection portion that is far away from the main board body may be larger than a cross-sectional area of the connection portion. In this way, counteraction is generated between a step surface in the connection groove and the limiting portion of the connection protrusion, so that connection strength between the lower bracket and the main board body can be enhanced, and the integrity and the reliability of the lower shaft board can be improved.

In a possible implementation, a first pin hole is provided at each of two ends of the upper shaft board in the length direction. A second pin hole is provided at each of two ends of the lower shaft board in a length direction. The first pin hole correspondingly communicates with the second pin hole. A positioning pin is inserted into the first pin hole and the second pin hole.

The first pin hole is provided at each of the two ends of the upper shaft board in the length direction, the second pin hole corresponding to the first pin hole is provided at each of the two ends of the lower shaft board in the length direction, and the positioning pin is inserted into the first pin hole of the upper shaft board and the second pin hole of the lower shaft board, to basically position and connect the upper shaft board and the lower shaft board, so that positioning precision of the main shaft can be improved. In addition, space entirely occupied by the first pin hole of the upper shaft board, the second pin hole of the lower shaft board, and the positioning pin is small, to help reduce a thickness of the main shaft, satisfy the lightening and thinning of the main shaft, and improve reliability of the main shaft.

In a possible implementation, a mounting groove is provided on the upper shaft board. The mounting groove is close to the two ends of the upper shaft board in the length direction and corresponds to the first pin hole. The first pin hole communicates with a groove wall of the mounting groove.

The mounting groove is provided on the upper shaft board, so that the mounting groove communicates with the first pin hole, and the mounting groove can form a mounting base of the positioning pin. The positioning pin extends into the mounting groove to be aligned with the first pin hole, so that the positioning pin smoothly penetrates through the first pin hole of the upper shaft board and the second pin hole of the lower shaft board, to basically connect the upper shaft board and the lower shaft board.

In a possible implementation, a fixing member is disposed in the mounting groove, and the fixing member abuts between an end portion of the positioning pin and the groove wall of the mounting groove.

The fixing member is disposed in the mounting groove, and the fixing member abuts between the end portion of the positioning pin and the groove wall of the mounting groove, so that the fixing member blocks the positioning pin, and the positioning pin can be prevented from being loosened, thereby ensuring reliable connection between an end portion of the upper shaft board and an end portion of the lower shaft board.

In a possible implementation, the first pin hole extends along the length direction of the upper shaft board, and the second pin hole extends along the length direction of the lower shaft board.

The first pin hole of the upper shaft board and the second pin hole of the lower shaft board extend along a length direction of the main shaft, to facilitate disposition of the first pin hole and the second pin hole, so that the upper shaft board is in fitting connection to the lower shaft board. In addition, the main shaft does not easily generate an action force in a direction other than the length direction of the main shaft, so that stability and the reliability of the main shaft can be improved.

In a possible implementation, two first pin holes are provided at each end of the upper shaft board, and the two first pin holes are respectively close to two sides of the upper shaft board in a width direction.

Two second pin holes are provided at each end of the lower shaft board, and the two second pin holes are respectively close to two sides of the lower shaft board in a width direction.

In a possible implementation, the two first pin holes at each end of the upper shaft board are symmetrically arranged along a center line of the upper shaft board.

The two second pin holes at each end of the lower shaft board are symmetrically arranged along a center line of the lower shaft board.

The two first pin holes at each end of the upper shaft board are symmetrically arranged along the center line of the upper shaft board, the two second pin holes at each end of the lower shaft board are symmetrically arranged along the center line of the lower shaft board, and the two positioning pins at each end of the main shaft are symmetrically arranged along a center line of the main shaft. In this way, structural symmetry of the two ends of the main shaft is good, and forces borne by the main shaft are balanced.

In a possible implementation, an avoidance groove is provided at each of two ends of the main shaft in a length direction, and the avoidance groove is located on a side on which a foldable screen is located.

The avoidance groove is provided at each of the two ends of the main shaft in the length direction, so that the avoidance groove faces the foldable screen, and protective space is formed in a gap between the foldable screen and a bottom of the avoidance groove, to avoid hard collision between the foldable screen and the main shaft in a risk scenario such as collision or falling. In this way, the foldable screen can be prevented from being fragmented due to an external force, integrity of the foldable screen is protected, and collision reliability of an electronic device is improved.

In a possible implementation, a groove width of the avoidance groove gradually increases from a center of the main shaft to an end portion of the main shaft along the length direction of the main shaft.

From the center of the main shaft to the end portion of the main shaft, the groove width of the avoidance groove gradually increases, so that the avoidance groove does not affect an upper bracket close to the end portion of the main shaft, thereby ensuring structural strength of the upper bracket. In addition, being closer to the end portion of the main shaft indicates a larger groove width of the avoidance groove and more accommodating space, so that the avoidance groove is sufficient for accommodating a deformed part of the foldable screen, to ensure a protective function of the avoidance groove.

In a possible implementation, the avoidance groove is located between the two first pin holes along a width direction of the main shaft.

The avoidance groove is located between the two first pin holes at each end of the upper shaft board, so that the avoidance groove does not affect a board thickness of the upper shaft board at the first pin holes, to ensure that the upper shaft board has a sufficient thickness at the first pin holes, thereby ensuring structural strength and reliability of the upper shaft board.

In a possible implementation, one of the upper shaft board and the lower shaft board is provided with a positioning post, the other is provided with a positioning hole, and the positioning post is inserted into the positioning hole.

One of the upper shaft board and the lower shaft board is provided with the positioning post, the other is provided with the positioning hole, and the positioning post is inserted into the positioning hole, to implement fitting and positioning between the upper shaft board and the lower shaft board.

In a possible implementation, the positioning post is provided close to each of two ends of one of the upper shaft board and the lower shaft board in the length direction, and the positioning hole is provided close to each of two ends of the other of the upper shaft board and the lower shaft board in the length direction.

A positioning structure is disposed close to each of the two ends of the main shaft in the length direction, to perform fitting and positioning on the upper shaft board and the lower shaft board at the two ends of the main shaft. In this way, there are fewer positioning structures on the main shaft, to facilitate positioning and assembly of the upper shaft board and the lower shaft board. In addition, a distance between the two positioning structures on the main shaft is large, so that the positioning precision of the main shaft can be improved.

In a possible implementation, the positioning post is located on a center line of one of the upper shaft board and the lower shaft board, and the positioning hole is located on a center line of the other of the upper shaft board and the lower shaft board.

The positioning structure is disposed on a center line in the width direction of the main shaft, so that only one group of positioning structures fitting each other needs to be disposed at the two ends of the main shaft in the length direction, thereby facilitating assembly of the main shaft. In addition, distances between the positioning structures and the two ends of the main shaft in the width direction are equivalent, so that the positioning precision of the main shaft can be improved, and the main shaft is more stable and reliable.

In a possible implementation, the upper brackets are tightly attached to the lower brackets.

The upper brackets of the upper shaft board are tightly attached to the lower brackets of the lower shaft board, so that the upper brackets and the lower brackets can transfer an external force to each other, and performance of the main shaft to resist the external force can be improved, to prevent deformation of the main shaft, improve precision of movement of the rotary shaft mechanism, and prolong a service life of the rotary shaft mechanism.

In a possible implementation, the main shaft is provided with at least one strengthening portion. The strengthening portion protrudes on a side surface of one of the upper shaft board and the lower shaft board that faces the other.

The at least one strengthening portion is disposed on the main shaft, and the strengthening portion protrudes on the side surface of one of the upper shaft board and the lower shaft board that faces the other, so that the structural strength of the main shaft can be enhanced, an arm length of the main shaft when the main shaft bears an external force is reduced, deformation of the main shaft is prevented, and force-bearing stability of the main shaft is improved.

n a possible implementation, the upper bracket is provided with a reinforcement portion. The reinforcement portion is located between oppositely provided openings along a width direction of the upper shaft board, and the reinforcement portion protrudes toward the lower bracket.

The lower bracket is provided with a reinforcement groove. The reinforcement groove corresponds to the reinforcement portion, and the reinforcement portion extends into the reinforcement groove.

The reinforcement portion is disposed between the oppositely provided openings of the upper bracket of the upper shaft board, and the reinforcement groove is provided at a position corresponding to the reinforcement portion on the lower bracket of the lower shaft board, and the reinforcement portion of the upper shaft board extends into the reinforcement groove of the lower shaft board. Through fitting between the upper shaft board and the lower shaft board, the structural strength of the entire main shaft can be enhanced, and the stability and the reliability of the main shaft can be improved.

According to a second aspect of this application, a production method of a main shaft is provided. The production method is used to produce the main shaft described above, and includes:
forming an upper shaft board by integrally forming a plurality of upper brackets and a plurality of support portions;
forming a lower shaft board by integrally forming a main board body and a plurality of lower brackets; and
connecting the upper shaft board to the lower shaft board, to form the main shaft.

According to the production method of the main shaft provided in this application, the plurality of upper brackets and the plurality of support portions are integrally formed, to form the integrated upper shaft board, and the plurality of lower brackets and the main board body are integrally formed or integrally connected, to form the integrated lower shaft board. The integrated upper shaft board and the integrated lower shaft board form the main shaft. In this way, the main shaft has a simple structure and good integrity, structural strength of the main shaft can be improved, and reliability of a rotary shaft mechanism is improved, thereby facilitating lightening and thinning of the main shaft. In addition, the main shaft is easy to be assembled, assembly precision is high, and precision of positioning each movable component is high, so that moving precision of the rotary shaft mechanism can be improved, and a problem that a foldable screen arches can be improved. In addition, flatness of the main shaft is high, so that a light and shadow effect of the foldable screen can be improved.

In a possible implementation, the forming an upper shaft board or the forming a lower shaft board includes:
integrally forming the upper shaft board or the lower shaft board by using an amorphous metal molding technology;
integrally forming the upper shaft board or the lower shaft board by using a metal powder injection molding technology; or
integrally forming the upper shaft board or the lower shaft board by using a 3D printing technology.

In a possible implementation, the forming a lower shaft board includes:
forming the main board body, where a connection groove is formed on the main board body; and
integrally forming each of the lower brackets on the main board body, to form a connection protrusion on each of the lower brackets, where the connection protrusion is integrally connected to the connection groove.

In a possible implementation, the forming a lower shaft board includes:
forming the lower brackets, where a connection groove is formed on each of the lower brackets; and
integrally forming the main board body on the lower brackets, to form a connection protrusion on the main board body, where the connection protrusion is integrally connected to the connection groove.

In a possible implementation, the forming a lower shaft board includes:
forming the main board body;
forming the lower brackets; and
welding the main board body to the lower brackets, to form the lower shaft board.

According to a third aspect of this application, a rotary shaft mechanism is provided, including:
the main shaft described above;
connection frames, movably connected on two sides of the main shaft in a width direction; and
a movable assembly, movably connected between the main shaft and each of the connection frames.

The rotary shaft mechanism provided in this application includes the main shaft, the connection frames movably connected on the two sides of the main shaft, and the movable assembly movably connected between the main shaft and each of the connection frames. In the main shaft, the plurality of upper brackets and the plurality of support portions are integrally formed, to form the integrated upper shaft board, and the plurality of lower brackets and the main board body are integrally formed or integrally connected, to form the integrated lower shaft board. The integrated upper shaft board and the integrated lower shaft board form the main shaft. In this way, the main shaft has a simple structure and good integrity, structural strength of the main shaft can be improved, and reliability of a rotary shaft mechanism is improved, thereby facilitating lightening and thinning of the main shaft. In addition, the main shaft is easy to be assembled, assembly precision is high, and precision of positioning each movable component is high, so that moving precision of the rotary shaft mechanism can be improved, and a problem that a foldable screen arches can be improved. In addition, flatness of the main shaft is high, so that a light and shadow effect of the foldable screen can be improved.

According to a fourth aspect of this application, an electronic device is provided, including a first housing, a second housing, a foldable screen, and the rotary shaft mechanism described above.

The first housing and the second housing are respectively connected on two sides of the rotary shaft mechanism. The foldable screen is mounted to the first housing and the second housing. The foldable screen is supported by the rotary shaft mechanism.

The electronic device provided in this application includes the first housing, the second housing, the rotary shaft mechanism connected between the first housing and the second housing, and the foldable screen mounted to the first housing and the second housing. The rotary shaft mechanism includes the main shaft, the connection frames movably connected on the two sides of the main shaft, and the movable assembly movably connected between the main shaft and each of the connection frames. In the main shaft, the plurality of upper brackets and the plurality of support portions are integrally formed, to form the integrated upper shaft board, and the plurality of lower brackets and the main board body are integrally formed or integrally connected, to form the integrated lower shaft board. The integrated upper shaft board and the integrated lower shaft board form the main shaft. In this way, the main shaft has a simple structure and good integrity, structural strength of the main shaft can be improved, and reliability of a rotary shaft mechanism is improved, thereby facilitating lightening and thinning of the main shaft. In addition, the main shaft is easy to be assembled, assembly precision is high, and precision of positioning each movable component is high, so that moving precision of the rotary shaft mechanism can be improved, and a problem that a foldable screen arches can be improved. In addition, flatness of the main shaft is high, so that a light and shadow effect of the foldable screen can be improved.

### BRIEF DESCRIPTION OF DRAWINGS

FIG. 1 is a schematic diagram of a structure of an electronic device when the electronic device is in an unfolded state according to an embodiment of this application;
FIG. 2 is a schematic diagram of a structure of the electronic device in FIG. 1 when the electronic device is in a folded state;
FIG. 3 is a schematic diagram of a structure of the electronic device in FIG. 1 when the electronic device is in a semi-unfolded state;
FIG. 4 is a schematic exploded diagram of a structure of an electronic device according to an embodiment of this application;
FIG. 5 is an exploded view of a structure of a rotary shaft mechanism according to an embodiment of this application;
FIG. 6 is an exploded view of a structure of a main shaft in one view according to an embodiment of this application;
FIG. 7 is an exploded view of a structure of a main shaft in another view according to an embodiment of this application;
FIG. 8 is a schematic diagram of a structure of an upper shaft board in one view according to an embodiment of this application;
FIG. 9 is a schematic diagram of a structure of an upper shaft board in another view according to an embodiment of this application;
FIG. 10 is a schematic diagram of a structure of a lower shaft board according to an embodiment of this application;
FIG. 11 is an exploded view of a structure of a lower shaft board according to an embodiment of this application;
FIG. 12 is a diagram of a partial structure of a lower shaft board according to an embodiment of this application;
FIG. 13 is an exploded view of a structure of the lower shaft board in FIG. 12;
FIG. 14 is a cross-sectional view of the lower shaft board in FIG. 12;
FIG. 15 is a diagram of a partial structure of another lower shaft board according to an embodiment of this application;
FIG. 16 is an exploded view of a structure of the lower shaft board in FIG. 15;
FIG. 17 is a cross-sectional view of the lower shaft board in FIG. 15;
FIG. 18 is a half-sectional view of a main shaft according to an embodiment of this application;
FIG. 19 is a partial enlarged view of a structure of a part A in FIG. 9;
FIG. 20 is a partial enlarged view of a structure of a part B in FIG. 10;
FIG. 21 is a diagram of a partial structure of an end portion of an upper shaft board according to an embodiment of this application;
FIG. 22 is a diagram of a partial structure of an end portion of a lower shaft board according to an embodiment of this application;
FIG. 23 is a partial cross-sectional view of an end portion of a main shaft according to an embodiment of this application;
FIG. 24 is another cross-sectional view of an end portion of a main shaft according to an embodiment of this application; and
FIG. 25 is a flowchart of steps of a production method of a main shaft according to an embodiment of this application.

Descriptions of reference numerals:
1-display screen; 1a-foldable screen; 1b-bar-type screen;
11-first non-bendable portion; 12-bendable portion; 13-second non-bendable portion;
2-housing assembly;
10-first housing; 20-second housing;
201-middle frame; 202-rear cover;
30-rotary shaft mechanism;
100-main shaft; 200-movable assembly; 300-damping synchronization structure;
110-upper shaft board; 120-lower shaft board; 130-positioning pin; 140-locking member; 210-primary swing arm; 220-secondary swing arm; 230-rotary shaft; 310-damping component; 320-synchronization component;
111-upper bracket; 112-support portion; 113-positioning hole; 114-first pin hole; 115-mounting groove; 116-fixing member; 117-avoidance groove; 121-lower bracket; 122-main board body; 123-strengthening portion; 124-stop portion; 125-positioning post; 126-second pin hole;
1111-opening; 1112-reinforcement portion; 1201-connection groove; 1202-connection protrusion; 1211-reinforcement groove;
12011-first groove segment; 12012-second groove segment; 12021-connection portion; and 12022-limiting portion.

### DESCRIPTION OF EMBODIMENTS

Terms used in implementations of this application are merely used to explain specific embodiments of this application, but are not intended to limit this application.

An embodiment of this application provides an electronic device. The electronic device may be a foldable electronic device. In addition, the electronic device may be a consumer electronic product. For example, the electronic device includes, but is not limited to, a foldable electronic device such as a foldable mobile phone, a laptop computer (laptop computer), a notebook computer, a netbook, a personal digital assistant (personal digital assistant, PDA), a personal computer, a multimedia player, an ebook reader, a vehicle-mounted device, a virtual reality (virtual reality, VR) device, an augmented reality (augmented reality, AR) device, or a wearable device. The wearable device includes, but is not limited to, a smart band, a smart watch, a smart head-mounted display, smart glasses, and the like.

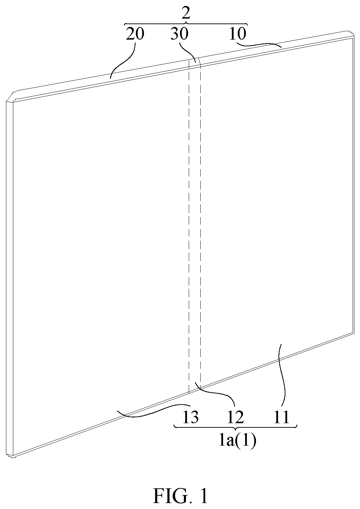

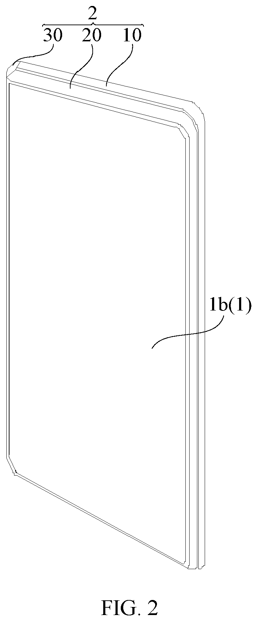

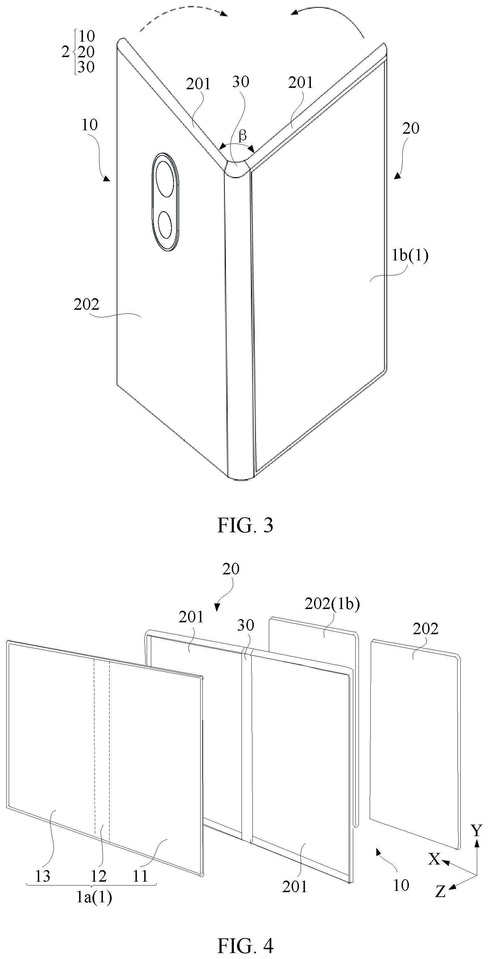

FIG. 1 is a schematic diagram of a structure of an electronic device when the electronic device is in an unfolded state according to an embodiment of this application. FIG. 2 is a schematic diagram of a structure of the electronic device in FIG. 1 when the electronic device is in a folded state. FIG. 3 is a schematic diagram of a structure of the electronic device in FIG. 1 when the electronic device is in a semi-unfolded state.

Refer to FIG. 1 to FIG. 3, this embodiment is described by using an example in which the electronic device is a foldable mobile phone.

For the electronic device, the electronic device may have different use states in different use scenarios. FIG. 1 shows the electronic device in the unfolded state. An unfolding angle α of the electronic device is, for example, 180°. In this case, the electronic device can implement large-screen display. FIG. 2 shows the electronic device in the folded state. In this case, the electronic device has a small volume and is convenient to carry. FIG. 3 shows the electronic device in the semi-unfolded state. In this case, the electronic device hovers at an angle between the unfolded state and the folded state. For example, a hovering angle β of the electronic device may be 120°, 130°, 140°, or 150°.

It should be noted that a slight deviation is allowed for all angles described by using an example in this embodiment. For example, that the unfolding angle α of the electronic device shown in FIG. 1 is 180° refers to that the unfolding angle α may be 180°, or may be approximately 180°, for example, 170°, 175°, 185°, or 190°. An angle used as an example for description below may be understood similarly.

In addition, the electronic device shown in FIG. 1 to FIG. 3 is an electronic device that can be folded once, and the electronic device includes two parts that can rotate relative to each other. When the two parts are rotated to be coplanar, the electronic device is in the unfolded state (as shown in FIG. 1). When the two parts are rotated to be stacked on each other, the electronic device is in the folded state (as shown in FIG. 2). When the two parts are rotated to an angle at which the electronic device hovers between the unfolded state and the folded state, the electronic device is in the semi-unfolded state (as shown in FIG. 3).

In another implementation, the electronic device may alternatively be an electronic device that can be folded for two or more times. In this case, the electronic device may include a plurality of parts that are successively rotated and connected. Two adjacent ones of the parts may be far away from each other, so that the electronic device is unfolded to the unfolded state. Alternatively, two adjacent ones of the parts may be close to each other, so that the electronic device is folded to the folded state.

FIG. 4 is a schematic exploded diagram of a structure of an electronic device according to an embodiment of this application. As shown in FIG. 4, the electronic device includes a display screen 1 and a housing assembly 2. One side surface of the display screen 1 is configured to display image information. Generally, the side surface of the display screen 1 is defined as a front surface of the display screen 1, and the other side surface opposite to the front surface of the display screen 1 is defined as a back surface of the display screen 1. The housing assembly 2 is disposed surrounding a peripheral side and a back side of the display screen 1, and is configured to support, fix, and protect the display screen 1. The front surface of the display screen 1 is exposed out of the housing assembly 2, for a user to view content displayed on the display screen 1 or perform an input operation on the electronic device.

The display screen 1 of the electronic device may include a foldable screen 1a. The foldable screen 1a may include a first non-bendable portion 11, a bendable portion 12, and a second non-bendable portion 13 that are successively arranged along a first direction. In other words, the bendable portion 12 is located between the first non-bendable portion 11 and the second non-bendable portion 13 in the first direction. A manner of folding the electronic device may be horizontal folding shown in FIG. 1 to FIG. 3. In this case, the first direction may be a direction X shown in FIG. 4. Certainly, the manner of folding the electronic device may alternatively be vertical folding. This is not limited in this embodiment.

For example, the foldable screen 1a may be made of a flexible material, so that the bendable portion 12 is bendable. The foldable screen 1a may be an organic light-emitting diode (organic light-emitting diode, OLED) display screen.

The housing assembly 2 is configured to support and fix the foldable screen 1a, and drive the foldable screen 1a to be switched between a folded state and an unfolded state. Refer to FIG. 4, the housing assembly 2 includes a first housing 10, a second housing 20, and a rotary shaft mechanism 30. The rotary shaft mechanism 30 is connected between the first housing 10 and the second housing 20, and the first housing 10 is rotatably connected to the second housing 20 by using the rotary shaft mechanism 30. Therefore, relative rotation between the first housing 10 and the second housing 20 is implemented.

The first housing 10 supports and fixes the first non-bendable portion 11 of the foldable screen 1a, and the second housing 20 supports and fixes the second non-bendable portion 13 of the foldable screen 1a. In other words, the first non-bendable portion 11 of the foldable screen 1a is fixedly connected to the first housing 10, the second non-bendable portion 13 of the foldable screen 1a is fixedly connected to the second housing 20, and the bendable portion 12 of the foldable screen 1a is disposed corresponding to the rotary shaft mechanism 30.

During use of the electronic device, the first non-bendable portion 11 and the second non-bendable portion 13 of the foldable screen 1a remain in a planar state, and the bendable portion 12 of the foldable screen 1a can be bent. When the rotary shaft mechanism 30 drives the first housing 10 and the second housing 20 to rotate relative to each other, orientations of the first non-bendable portion 11 and the second non-bendable portion 13 of the foldable screen 1a change with the rotation, and the bendable portion 12 of the foldable screen 1a is bent or flattened as the orientations of the first non-bendable portion 11 and the second non-bendable portion 13 change.

The first housing 10 and the second housing 20 may be rotated in a direction away from each other until the first housing 10 and the second housing 20 are coplanar. In this case, the housing assembly 2 is in the unfolded state, and the foldable screen 1a is in the unfolded state as the housing assembly 2 is unfolded (as shown in FIG. 1). The first housing 10 and the second housing 20 may alternatively be rotated toward each other until the first housing 10 and the second housing 20 are stacked. In this case, the housing assembly 2 is in the folded state, and the foldable screen 1a is in the folded state as the housing assembly 2 is folded (as shown in FIG. 2). It should be noted that an example in which the electronic device is an inward-foldable electronic device is used in this embodiment. When the electronic device is in the folded state, the first non-bendable portion 11 and the second non-bendable portion 13 of the foldable screen 1a are attached to each other, the housing assembly 2 is disposed surrounding the foldable screen 1a, and the foldable screen 1a is located between the first housing 10 and the second housing 20. In this case, when the inward-foldable electronic device is in the folded state, the housing assembly 2 can protect the foldable screen 1a, to prevent the foldable screen 1a from being scuffed by a hard object.

If the inward-foldable electronic device needs to implement a display function in the folded state, a bar-type screen 1b may be added to a back surface of the housing. When the electronic device is in the folded state, the display function is implemented depending on the bar-type screen 1b (refer to FIG. 2 or FIG. 3). In other words, the inward-foldable electronic device may include the foldable screen 1a and the bar-type screen 1b. The foldable screen 1a may be mounted on a front surface of the housing assembly 2. With movement of the housing assembly 2, the foldable screen 1a may be switched between the unfolded state and the folded state. When the electronic device is in the folded state, the foldable screen 1a is invisible to the outside. The bar-type screen 1b may be mounted on the back surface of the housing assembly 2, and the bar-type screen 1b performs displaying when the electronic device is in the folded state.

In another example, the electronic device may alternatively be an outward-foldable electronic device. When the electronic device is in the folded state, the first non-bendable portion 11 and the second non-bendable portion 13 of the foldable screen 1a are opposite to each other, and the housing assembly 2 is located between the first non-bendable portion 11 and the second non-bendable portion 13. In other words, when the outward-foldable electronic device is in the folded state, the foldable screen 1a is disposed surrounding the first housing 10 and the second housing 20. The foldable screen 1a is visible to a user, and the display function may be implemented by using the foldable screen 1a. Therefore, no bar-type screen 1b needs to be additionally added to the back surface of the housing to implement the display function of the electronic device in the folded state.

In addition, in some implementations, the electronic device, in particular, the inward-foldable electronic device, may hover at an angle between the unfolded state and the folded state. For example, a hovering angle of the electronic device may be 120°, 130°, 140°, or 150°. The housing assembly 2 may be enabled to hover in a semi-unfolded state between the folded state and the unfolded state depending on a damping force provided by the housing assembly 2, and the foldable screen 1a stays in the semi-unfolded state with the housing assembly 2. In this case, the bendable portion 12 of the foldable screen 1a is also bent, and a bending degree of the bendable portion 12 is less than a bending degree when the bendable portion 12 is in the folded state. The first non-bendable portion 11 and the second non-bendable portion 13 of the foldable screen 1a are inclined relative to each other, and an angle between the first non-bendable portion 11 and the second non-bendable portion 13 is, for example, 120°, 130°, 140°, or 150°.

Still refer to FIG. 4, in the housing assembly 2 of the foldable electronic device, the first housing 10 and the second housing 20 each may include a middle frame 201, and the first non-bendable portion 11 and the second non-bendable portion 13 of the foldable screen 1a may be supported on a front surface of the corresponding middle frame 201. For an outward-foldable electronic device or an inward-foldable electronic device on which no bar-type screen 1b is additionally disposed, the first housing 10 and the second housing 20 of the electronic device 1 each may further include a rear cover 202. The rear cover 202 is connected to a side surface of the middle frame 201 that faces away from the foldable screen 1a. For an inward-foldable electronic device on which the bar-type screen 1b is additionally disposed, one of the first housing 10 and the second housing 20 may not include the rear cover 202, and instead, the bar-type screen 1b is mounted on a back surface of the middle frame 201.

In the first housing 10 and the second housing 20, the middle frame 201 and the rear cover 202 (or the bar-type screen 1b) jointly enclose an accommodating cavity. The accommodating cavity is configured to mount some functional components (not shown in the figure) of the electronic device. For example, the accommodating cavity is configured to mount components such as a circuit board, a battery, a camera module, a microphone, and a speaker.

The rotary shaft mechanism 30 in this embodiment of this application is described in detail below.

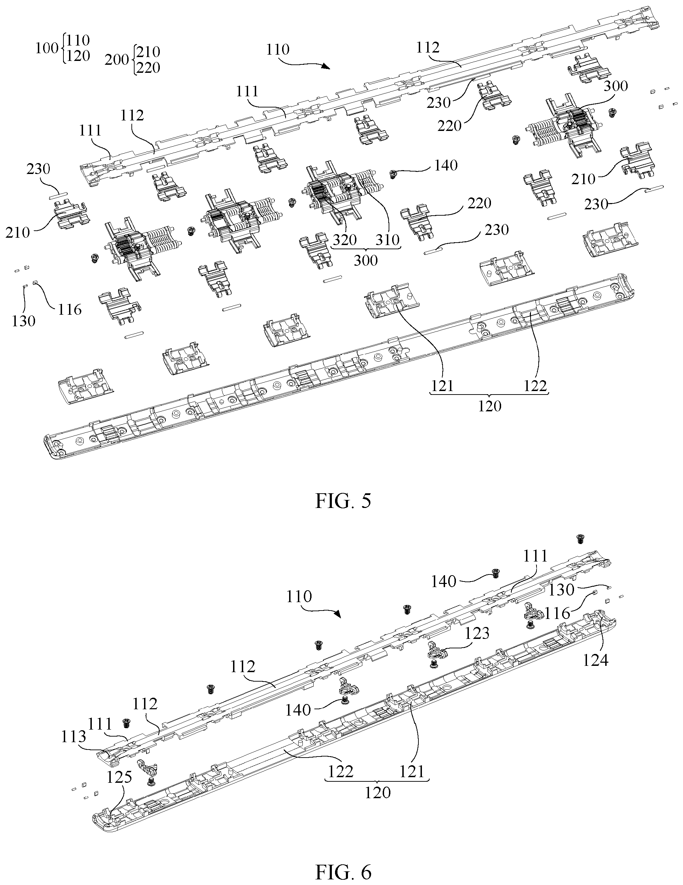

FIG. 5 is an exploded view of a structure of a rotary shaft mechanism according to an embodiment of this application. Refer to FIG. 5, the rotary shaft mechanism 30 includes a main shaft 100 and connection frames (not shown in the figure). The main shaft 100 is a main support structure of the rotary shaft mechanism 30. The connection frames are movably connected on two sides of the main shaft 100. The connection frames on the two sides of the main shaft 100 are respectively connected to the first housing 10 and the second housing 20. The main shaft 100 may be lengthened along side edges of opposite sides of the first housing 10 and the second housing 20. The main shaft 100 is equivalent to a rotary shaft of the housing assembly 2. The first housing 10 and the second housing 20 rotate around the main shaft 100. The connection frames on the two sides of the main shaft 100 synchronously move relative to the main shaft 100, to drive the first housing 10 and the second housing 20 to synchronously move relative to each other, so that the housing assembly 2 is switched between the unfolded state and the folded state.

The rotary shaft mechanism 30 further includes some functional components connected between the main shaft 100 and each of the connection frames. For example, the functional components may include components such as a movable assembly 200 and a damping synchronization structure 300, and the functional components may be movably connected between the main shaft 100 and each of the connection frames. The movable assembly 200 is configured to implement rotation and translation of each of the connection frames relative to the main shaft 100, so that the rotary shaft mechanism 30 drives the first housing 10 and the second housing 20 to rotate relative to each other, and the housing assembly 2 is switched between the unfolded state and the folded state. The damping synchronization structure 300 is configured to provide a damping force, to ensure stability of the housing assembly 2 in the unfolded state, the folded state, and a state conversion process, and improve an operation feeling of the electronic device. In addition, the damping synchronization structure 300 is further configured to enable the connection frames on the two sides of the main shaft 100 to synchronously move relative to the main shaft 100, so that the first housing 10 and the second housing 20 synchronously rotate and translate, thereby ensuring stability and reliability of movement of the housing assembly 2.

When the connection frames on the two sides of the main shaft 100 are unfolded on the two sides of the main shaft 100, the connection frames on the two sides of the main shaft 100 are coplanar with the main shaft 100. In this case, the rotary shaft mechanism 30 is in the unfolded state, and the electronic device is in the unfolded state with the rotary shaft mechanism 30. When the connection frames on the two sides of the main shaft 100 are close to each other and are folded on one side of the main shaft 100 (in a thickness direction), the connection frames on the two sides of the main shaft 100 are approximately perpendicular to the main shaft 100 and are oppositely disposed. In this case, the rotary shaft mechanism 30 is in the folded state, and the electronic device is in the folded state with the rotary shaft mechanism 30.

Descriptions are provided below by using an example in which the rotary shaft mechanism 30 is used in an inward-foldable electronic device.

For the connection frames connected on the two sides of the main shaft 100, in some implementations, the connection frame on each side of the main shaft 100 may be an integrated and elongated connection frame. Two ends of the connection frame may extend to two ends of the main shaft 100. A connection frame connected between the main shaft 100 and the first housing 10 (or the second housing 20) is of an integral structure. In this way, the connection frame has good integrity and is easy to be assembled, and connection strength and reliability between the rotary shaft mechanism 30 and the housing assembly 2 are high. In some other implementations, the connection frame on each side of the main shaft 100 may be of a multi-segment structure, in other words, there may be a plurality of connection frames on each side of the main shaft 100. The connection frames may be disposed spaced away along a length direction of the main shaft 100. The connection frames are disposed corresponding to regions in which the foregoing functional components are located. There may be a gap between adjacent ones of the connection frames. This is not limited in this embodiment of this application.

In addition, for a single connection frame, in an example, the connection frame may be of an integrated structure. The connection frame may be provided with a structure such as a groove or a hole. A part of structures of the foregoing functional components may be inserted into the connection frame. In another example, the connection frame may alternatively include a connection block and a door panel, and the door panel may be connected to a side surface of the connection block that faces the foldable screen 1a. The connection block may have a large thickness, and the foregoing functional components are mounted by using the connection block. The door panel may have a small thickness, and the door panel is mainly configured to support the foldable screen 1a. In this case, a structure such as a groove or a hole provided on the connection block may be exposed on a side surface of the connection block that faces the door panel, to facilitate assembly of the foregoing functional components and the connection block.

Still refer to FIG. 5, the movable assembly 200 connected between the main shaft 100 and the connection frame may include a primary swing arm 210 and a secondary swing arm 220. For example, the primary swing arm 210 may be connected to each of two ends of the main shaft 100 in the length direction, so that moving tracks of two ends of the rotary shaft mechanism 30 are limited by using the primary swing arm 210, thereby ensuring precision of a moving track of the rotary shaft mechanism 30. The secondary swing arm 220 may be located between the primary swing arms 210 at the two ends, and a plurality of secondary swing arms 220 may be arranged spaced away along the length direction of the main shaft 100. Based on the primary swing arm 210, through cooperation of the secondary swing arm 220, moving precision of the rotary shaft mechanism 30 can be improved, and stability and reliability of movement of the rotary shaft mechanism 30 are ensured.

One end of each of the primary swing arm 210 and the secondary swing arm 220 that faces toward the main shaft 100 may be an arc-shaped portion. Grooves provided at positions corresponding to the primary swing arm 210 and the secondary swing arm 220 on the main shaft 100 may be arc-shaped grooves. In this way, the primary swing arm 210 and the secondary swing arm 220 may rotate around the main shaft 100 and slide relative to the main shaft 100. The primary swing arm 210 and the secondary swing arm 220 may drive the connection frame to rotate and translate relative to the main shaft 100, so that the rotary shaft mechanism 30 is switched between the unfolded state and the folded state. For connection between the primary swing arm 210 and the connection frame and connection between the secondary swing arm 220 and the connection frame, for example, the primary swing arm 210 and the secondary swing arm 220 each may be connected to the connection frame by using a rotary shaft 230. In other words, the primary swing arm 210 and the secondary swing arm 220 each are in rotary connection to the connection frame. Certainly, the primary swing arm 210 and the secondary swing arm 220 each may be in slidable connection to the connection frame. Alternatively, the primary swing arm 210 and the secondary swing arm 220 each are in rotary or slidable connection to the connection frame. Alternatively, one of the primary swing arm 210 and the secondary swing arm 220 is in rotary connection to the connection frame, and the other is in slidable connection to the connection frame.

Still refer to FIG. 5, in this embodiment, a damping component 310 and a synchronization component 320 are integrated to form the foregoing damping synchronization structure 300. As the connection frames on the two sides of the main shaft 100 move relative to the main shaft 100, in the damping synchronization structure 300, the damping component 310 and the synchronization component 320 are linked, to synchronously move the connection frames on the two sides of the main shaft 100 relative to the main shaft 100 while providing the damping force for the rotary shaft mechanism 30. In this way, the damping synchronization structure 300 is highly integrated and occupies small space, and more space may be reserved for the rotary shaft mechanism 30, thereby facilitating disposition of other components in the rotary shaft mechanism 30. Alternatively, more damping synchronization structures 300 may be disposed in the rotary shaft mechanism 30, to enhance an effect of the damping synchronization structure 300 and improve stability and reliability of the rotary shaft mechanism 30.

Certainly, in another embodiment, the damping component 310 and the synchronization component 320 may alternatively be disposed separately, and the damping component 310 and the synchronization component 320 may be arranged spaced away, and are not connected to each other. In this case, the damping component 310 is only configured to provide the damping force, and the synchronization component 320 is only configured to synchronously move the connection frames at the two sides of the main shaft 100 relative to the main shaft 100. This is not limited in this embodiment.

An inward-foldable electronic device is used as an example. In a related technology, a main shaft usually includes a shaft cover, a bracket, and a support plate. The bracket and the support plate are both connected to the shaft cover. There may be a plurality of brackets. The bracket is provided with structures such as a groove and a hole. The foregoing movable component is mounted on the bracket by using the structures such as the groove and the hole. The support plate may fill space between the brackets. The bracket may be fixedly connected to the shaft cover through glue dispensing or screw locking, and the support plate is fixedly connected to the shaft cover mainly through glue dispensing.

However, with lightening and thinning of the electronic device, thicknesses of the shaft cover, the bracket, and the support plate are continuously reduced, strength of the main shaft continuously deteriorates, and reliability of the main shaft is affected. In addition, because the main shaft has many components, assembly of the main shaft is complex, and assembly costs are high. Low precision of positioning each movable component affects moving precision of the rotary shaft mechanism, and consequently, the foldable screen arches at a position of the rotary shaft mechanism.

The bracket is connected to the shaft cover through glue dispensing. As a result, connection strength between the bracket and the shaft cover is weak. When the electronic device falls, there is a risk that the main shaft cracks. In addition, it is difficult to control a thickness of dispensed glue. As a result, the bracket floats and flatness of the main shaft is affected. Further, a light and shadow effect of the foldable screen supported on the main shaft is affected. In addition, glue dispensing has a problem of a high defect rate in repair and disassembly. The bracket is connected to the shaft cover through screw locking. With lightening and thinning of the main shaft, a depth by which a screw is locked is insufficient, locking strength is insufficient, and the main shaft easily falls and cracks. In addition, screws located at a head end and a tail end of a rotary shaft need to avoid an accommodating groove provided at an end portion and configured to avoid cracking of the foldable screen when the foldable screen falls or collides, and locking space is extremely small. Consequently, further lightening and thinning of the main shaft are limited.

In view of this, an embodiment of this application improves the main shaft of the rotary shaft mechanism. The main shaft includes an upper shaft board and a lower shaft board that are connected to each other. The upper shaft board includes a plurality of upper brackets and a plurality of support portions. The upper brackets are arranged spaced away along a length direction of the upper shaft board. The support portions are connected between adjacent ones of the upper brackets. The lower shaft board includes a main board body and a plurality of lower brackets. The lower brackets are arranged spaced away along a length direction of the main board body, and are in one-to-one correspondence with the upper brackets. The lower brackets are all connected to the main board body. The plurality of upper brackets and the plurality of support portions are integrally formed, to form the integrated upper shaft board, and the plurality of lower brackets and the main board body are integrally formed or integrally connected, to form the integrated lower shaft board. The integrated upper shaft board and the integrated lower shaft board form the main shaft. In this way, the main shaft has a simple structure and good integrity, structural strength of the main shaft can be improved, and reliability of a rotary shaft mechanism is improved, thereby facilitating lightening and thinning of the main shaft. In addition, the main shaft is easy to be assembled, assembly precision is high, and precision of positioning each movable component is high, so that moving precision of the rotary shaft mechanism can be improved, and a problem that a foldable screen arches can be improved. In addition, flatness of the main shaft is high, so that a light and shadow effect of the foldable screen can be improved.

A main shaft 100 in a rotary shaft mechanism 30 in this embodiment of this application is described in detail below.

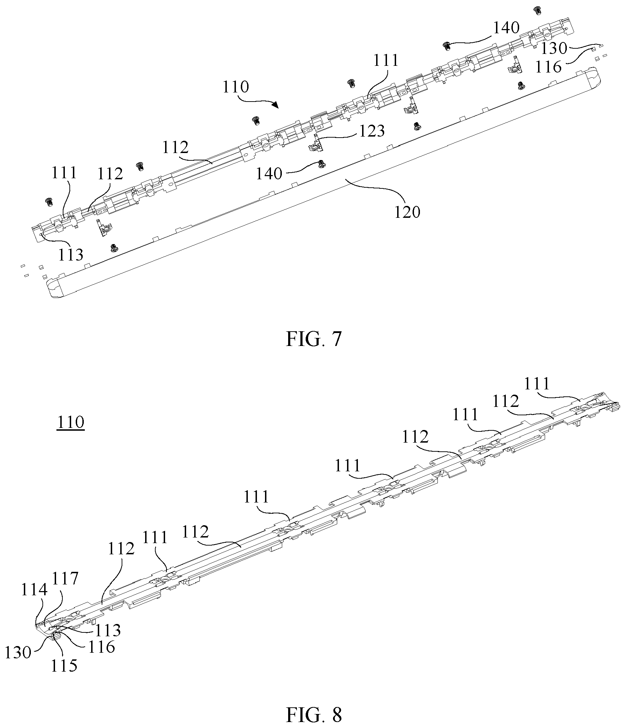

FIG. 6 is an exploded view of a structure of a main shaft in one view according to an embodiment of this application. FIG. 7 is an exploded view of a structure of a main shaft in another view according to an embodiment of this application.

Refer to FIG. 6 and FIG. 7, in this embodiment, the main shaft 100 includes an upper shaft board 110 and a lower shaft board 120. The upper shaft board 110 and the lower shaft board 120 are arranged up and down along a thickness direction of the main shaft 100, and are connected to each other, to jointly form the main shaft 100. Using an example in which the rotary shaft mechanism 30 is used in an inward-foldable electronic device, a side surface of the upper shaft board 110 that faces away from the lower shaft board 120 faces a foldable screen 1a, and the foldable screen 1a may be supported on the side surface of the upper shaft board 110. A side surface of the lower shaft board 120 that faces away from the upper shaft board 110 may be exposed out of the electronic device, and the side surface of the lower shaft board 120 may form a part of an appearance surface of the electronic device.

The upper shaft board 110 and the lower shaft board 120 each extend to two ends of the main shaft 100 along a length direction of the main shaft 100, and the upper shaft board 110 and the lower shaft board 120 each are an integral structural member. The upper shaft board 110 and the lower shaft board 120 jointly enclose structures such as a groove and a hole. For example, the upper shaft board 110 and the lower shaft board 120 jointly enclose structures such as an arc-shaped groove and a pin hole. These structures are configured to accommodate at least a part of structures of the foregoing functional components such as the movable assembly 200 and the damping synchronization structure 300, and serve as mounting bases of these functional components.

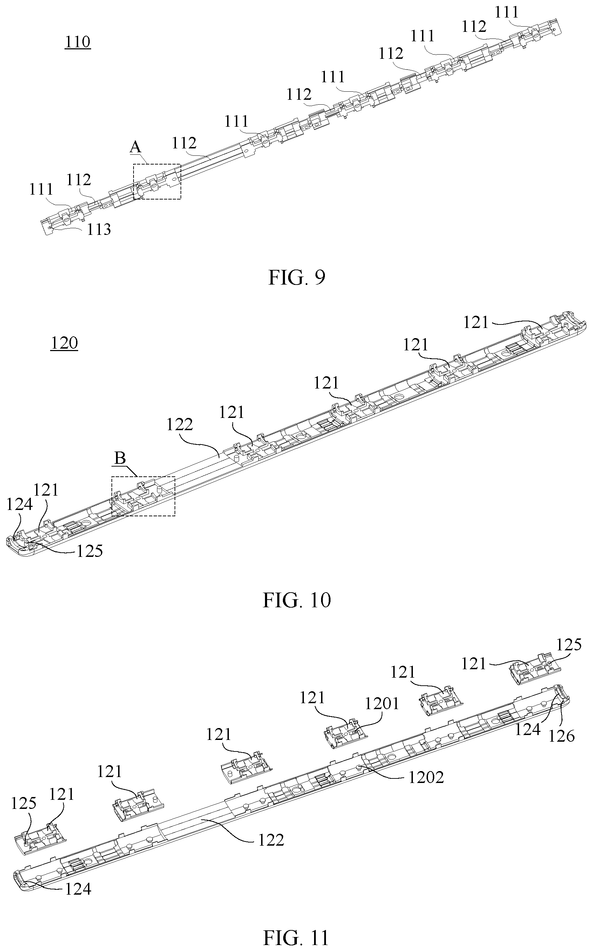

FIG. 8 is a schematic diagram of a structure of an upper shaft board in one view according to an embodiment of this application. FIG. 9 is a schematic diagram of a structure of an upper shaft board in another view according to an embodiment of this application. Refer to FIG. 8 and FIG. 9, the upper shaft board 110 may include a plurality of upper brackets 111 and a plurality of support portions 112. The upper brackets 111 may be arranged spaced away along a length direction of the upper shaft board 110. The support portions 112 may be connected between adjacent ones of the upper brackets 111. For example, when a distance between two adjacent ones of the upper brackets 111 is small, only one support portion 112 may be disposed between the two adjacent upper brackets 111. When a distance between two adjacent ones of the upper brackets 111 is large, a long support portion 112 or two or more short support portions 112 may be disposed between the two adjacent upper brackets 111.

The plurality of upper brackets 111 correspond to regions in which the foregoing functional components such as the movable assembly 200, the synchronization structure, and the damping structure need to be mounted in the main shaft 100. In other words, these functional components are mounted in regions in which the upper brackets 111 are located. The plurality of support portions 112 are configured to fill gaps between the adjacent ones of the upper brackets 111, so that the upper brackets 111 are connected together by using the plurality of support portions 112 to form an integrity. Therefore, the upper shaft board 110 forms an integral and elongated structure having a length equivalent to that of the main shaft 100.

The plurality of upper brackets 111 and the plurality of support portions 112 are integrally formed, to form the integrated upper shaft board 110, so that the upper shaft board 110 is an elongated integral structural member. In this way, the upper shaft board 110 has a simpler structure and better integrity, and structural strength of the upper shaft board 110 can be improved. Based on that the upper brackets 111 are disposed as the mounting bases of the functional components, the support portion 112 is disposed between the upper brackets 111, so that flatness of the upper shaft board 110 can be improved, a contact area between the upper shaft board 110 and the foldable screen 1a is increased, and a light and shadow effect of the foldable screen 1a is improved.

FIG. 10 is a schematic diagram of a structure of a lower shaft board according to an embodiment of this application. FIG. 11 is an exploded view of a structure of a lower shaft board according to an embodiment of this application. Refer to FIG. 10 and FIG. 11, the lower shaft board 120 may include a main board body 122 and a plurality of lower brackets 121. The main board body 122 may extend to two ends of the main shaft 100 along the length direction of the main shaft 100. The lower brackets 121 may be arranged spaced away along a length direction of the main board body 122. The lower brackets 121 are all connected to the main board body 122. An inward-foldable electronic device is used as an example. The main board body 122 may be used as a shaft cover of the main shaft 100, the lower bracket 121 is located on a side surface of the main board body 122 that faces the upper shaft board 110, and a side surface of the main board body 122 that faces away from the upper shaft board 110 may be used as the appearance surface of the main shaft 100. The plurality of lower brackets 121 correspond to the regions in which the foregoing functional components need to be mounted in the main shaft 100. In other words, these functional components are mounted in regions in which the lower brackets 121 are located.

The lower brackets 121 on the lower shaft board 120 may be in one-to-one correspondence with the upper brackets 111 on the upper shaft board 110. For example, positions of the lower brackets 121 completely overlap positions of the upper brackets 111, and shapes of the lower brackets 121 are completely symmetrical to shapes of the corresponding upper brackets 111. The upper brackets 111 and the lower brackets 121 jointly enclose the foregoing structures such as the groove and the hole, to mount the foregoing functional components between the upper brackets 111 and the lower brackets 121.

The plurality of lower brackets 121 are integrally formed or integrally connected to the main board body 122, to form the integrated lower shaft board 120, so that the lower shaft board 120 is also an elongated integral structural member. In this way, the lower shaft board 120 has a simpler structure and better integrity, and structural strength and reliability of the lower shaft board 120 can be improved. Because the lower bracket 121 and the main board body 122 are not connected through glue dispensing or screw locking, an assembly process of the lower shaft board 120 is saved, thereby helping reduce assembly costs of the main shaft 100.

The integrated upper shaft board 110 and the integrated lower shaft board 120 are assembled into the main shaft 100 (refer to FIG. 5), so that a structure of the main shaft 100 is simplified, and integrity of the main shaft 100 is improved. Under a same size, strength of the main shaft 100 can be greatly improved, thereby facilitating further reducing a thickness of the main shaft 100, and implementing lightening and thinning of the main shaft 100. In addition, the main shaft 100 is easy to be assembled, assembly precision is high, and positioning of each functional component is jointly determined by the upper shaft board 110 and the lower shaft board 120 that extend through the two ends of the main shaft 100 in the length direction, so that precision of a moving track of the rotary shaft mechanism 30 is improved, a problem that the foldable screen 1a arches can be improved.

For example, the upper shaft board 110 may be integrally formed by using a molding technology such as an amorphous metal molding technology, a metal powder injection molding technology (metal powder injection molding technology, MIM for short), or a 3D printing technology. Similarly, the lower shaft board 120 may also be integrally formed by using a molding technology such as the amorphous metal molding technology, the metal powder injection molding technology, or the 3D printing technology. In this case, the upper shaft board 110 and the lower shaft board 120 each may be entirely made of a metal material. For example, the upper shaft board 110 and the lower shaft board 120 each are entirely made of an alloy material such as titanium alloy or aluminum alloy.

The amorphous metal molding technology is a technology that metal or alloy is converted from liquid to a solid at an extremely high cooling speed much higher than that in a conventional solidification technology. In the metal powder injection molding technology, solid powders and an organic binder are uniformly mixed, granulated, and then injected, in a heated and plasticized state, into a mold cavity by using an injection molding machine for solidification and shaping. Then, the binder is removed from a molded preform by using a chemical or thermal decomposition method, and a final product is obtained through sintering and densification. In the 3D printing technology, a digital model is cut into slices, and then these slices are printed layer by layer and superposed one by one, to finally form a complete physical object.

For a manner of forming the lower shaft board 120, in some implementations, one of the lower bracket 121 and the main board body 122 is first formed. Then, the first formed one of the lower bracket 121 and the main board body 122 is used as a basic structure, and the other of the lower bracket 121 and the main board body 122 is integrally formed on the first formed one, to form the lower shaft board 120. In this way, the lower bracket 121 and the main board body 122 are still integrally formed, and the lower shaft board 120 is still an integrally formed member.

When one of the lower bracket 121 and the main board body 122 is first formed, and the other is integrally formed on the first formed one, to form the integrally formed lower shaft board 120, the lower bracket 121 and the main board body 122 may be produced by using different materials. For example, the lower bracket 121 and the main board body 122 each are produced by using a metal material, and a metal material of the lower bracket 121 and a metal material of the main board body 122 may be different. In this case, because the materials of the lower bracket 121 and the main board body 122 are different, there is an obvious division surface between the lower bracket 121 and the main board body 122.

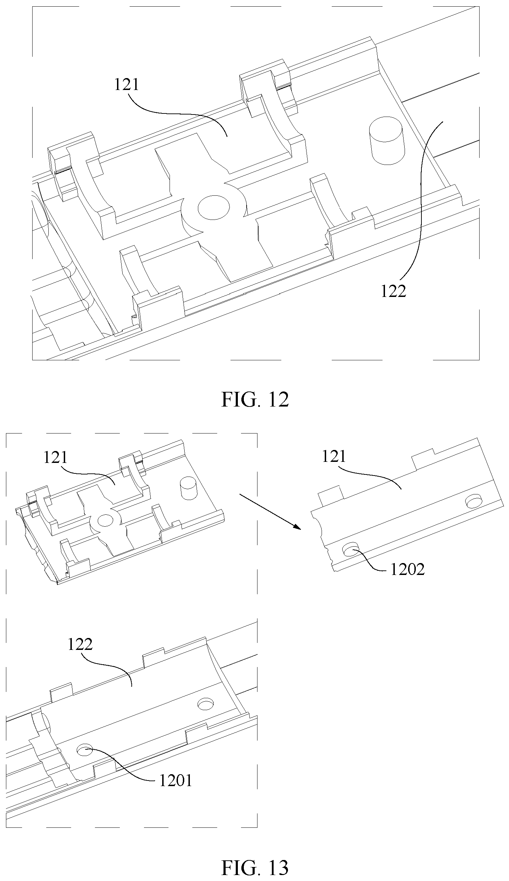

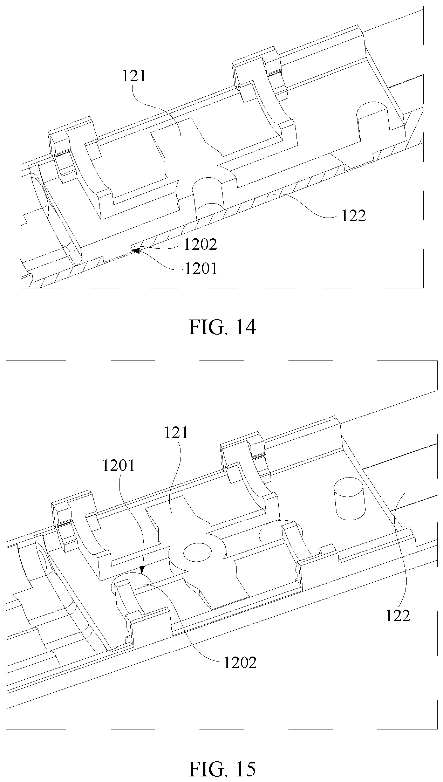

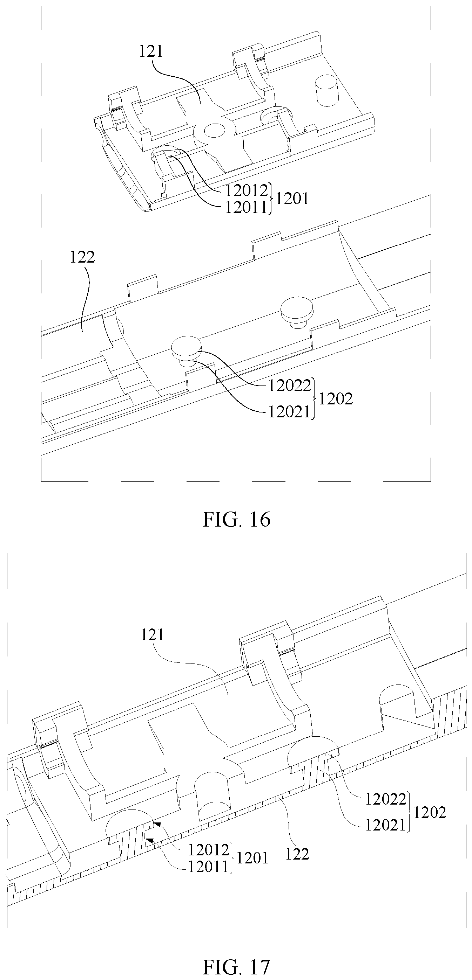

FIG. 12 is a diagram of a partial structure of a lower shaft board according to an embodiment of this application. FIG. 13 is an exploded view of a structure of the lower shaft board in FIG. 12. FIG. 14 is a cross-sectional view of the lower shaft board in FIG. 12. FIG. 15 is a diagram of a partial structure of another lower shaft board according to an embodiment of this application. FIG. 16 is an exploded view of a structure of the lower shaft board in FIG. 15. FIG. 17 is a cross-sectional view of the lower shaft board in FIG. 15.

Refer to FIG. 12 to FIG. 14 or FIG. 15 to FIG. 17, to make connection between the lower bracket 121 and the main board body 122 more reliable and more integrated, one of the lower bracket 121 and the main board body 122 is provided with a connection groove 1201, and the other is provided with a connection protrusion 1202. The connection protrusion 1202 extends into the connection groove 1201, and the connection protrusion 1202 is integrally connected to the connection groove 1201, so that the lower bracket 121 and the main board body 122 are integrally connected.

In this way, in addition to a contact surface in a plane direction of the lower shaft board 120, the lower bracket 121 and the main board body 122 also have a contact surface in a thickness direction of the lower shaft board 120, thereby increasing a contact area between the lower bracket 121 and the main board body 122 and enhancing reliability of integral connection between the lower bracket 121 and the main board body 122. Through mutual fitting of the connection protrusion 1202 and the connection groove 1201, a shear force between the lower bracket 121 and the main board body 122 in the thickness direction of the lower shaft board 120 can be increased, so that the lower bracket 121 is more firmly connected to the main board body 122, and problems such as cracking and separation of the lower shaft board 120 can be avoided.

Refer to FIG. 12 to FIG. 14, in an implementation, when the lower shaft board 120 is formed, the main board body 122 may be first formed. Then, the main board body 122 is used as a basic structure, the lower brackets 121 are formed on the main board body 122, and the lower brackets 121 and the main board body 122 are integrally formed into the lower shaft board 120. In this case, the first formed main board body 122 may be provided with the connection groove 1201. When each lower bracket 121 is integrally formed on the main board body 122, the material of the lower bracket 121 enters the connection groove 1201 on the main board body 122, to form a glue-pulling structure on the lower bracket 121. The glue-pulling structure is the connection protrusion 1202 that protrudes on a surface of the lower bracket 121.

Refer to FIG. 15 to FIG. 17, in another implementation, when the lower shaft board 120 is formed, the lower brackets 121 may be formed first, then, the lower brackets 121 are used as a basic structure, the main board body 122 is formed on the lower brackets 121, and the main board body 122 and the lower brackets 121 are integrally formed into the lower shaft board 120. In this case, each formed first lower bracket 121 may be provided with the connection groove 1201. When the main board body 122 is integrally formed on each lower bracket 121, the material of the main board body 122 enters the connection groove 1201 of each lower bracket 121, to form a glue-pulling structure on the main board body 122. The glue-pulling structure is the connection protrusion 1202 that protrudes on a surface of the main board body 122.

To form the connection groove 1201 on the first formed one of the lower bracket 121 and the main board body 122, a mold for forming the lower bracket 121 or the main board body 122 may be designed, so that the formed lower bracket 121 or main board body 122 is provided with the connection groove 1201. Alternatively, the lower bracket 121 or main board body 122 that is not provided with the connection groove 1201 is first formed by using a technology such as the amorphous metal molding technology or the metal powder injection molding technology, and then the lower bracket 121 or the main board body 122 is processed by using a computer numerical control (computer numerical control, computer numerical control machine tools) processing technology, to form the connection groove 1201.

Refer to FIG. 16 or FIG. 17, when the connection groove 1201 is formed on each lower bracket 121 and the connection protrusion 1202 is formed on the main board body 122, because the lower bracket 121 is not exposed on the appearance surface of the electronic device, the connection groove 1201 formed on the lower bracket 121 may be a through groove. In other words, the connection groove 1201 formed on the lower bracket 121 may penetrate through two side surfaces of the lower bracket 121 in a thickness direction. In this way, a contact area between the lower bracket 121 and the main board body 122 in the thickness direction of the lower shaft board 120 can be increased, and the shear force between the lower bracket 121 and the main board body 122 is increased. Further, integrity of the lower shaft board 120 is enhanced, and reliability of the lower shaft board 120 is improved.

In this case, because the lower bracket 121 has a large thickness, and the connection groove 1201 penetrating through the lower bracket 121 in the thickness direction has a sufficient depth, the connection groove 1201 may be disposed as a step groove. For example, the connection groove 1201 on the lower bracket 121 may include a first groove segment 12011 and a second groove segment 12012. The first groove segment 12011 and the second groove segment 12012 are successively provided along the thickness direction of the lower bracket 121. The second groove segment 12012 is located on a side of the first groove segment 12011 that faces away from the main board body 122, and a cross-sectional area of the second groove segment 12012 may be larger than a cross-sectional area of the first groove segment 12011.

Correspondingly, after the main board body 122 is integrally formed on the lower bracket 121, the connection protrusion 1202 formed on the main board body 122 may include a connection portion 12021 and a limiting portion 12022. One end of the connection portion 12021 is connected to a side surface of the main board body 122 that faces the lower bracket 121. The limiting portion 12022 is connected to one end of the connection portion 12021 that is far away from the main board body 122. A cross-sectional area of the limiting portion 12022 may be larger than a cross-sectional area of the connection portion 12021. The connection portion 12021 of the connection protrusion 1202 is integrally connected to the first groove segment 12011 of the connection groove 1201, and the limiting portion 12022 of the connection protrusion 1202 is integrally connected to the second groove segment 12012 of the connection groove 1201.

In this way, a step surface between the first groove segment 12011 and the second groove segment 12012 of the connection groove 1201 in the lower bracket 121 limits a position of the limiting portion 12022 of the connection protrusion 1202 on the main board body 122. The connection groove 1201 of the lower bracket 121 and the connection protrusion 1202 of the main board body 122 resist each other, and a shearing action between the connection groove 1201 and the connection protrusion 1202 is stronger, so that connection strength between the lower bracket 121 and the main board body 122 can be enhanced, and integrity and reliability of the lower shaft board 120 can be improved.

Certainly, when the main board body 122 has a sufficient thickness to provide the step groove on the main board body 122, the connection groove 1201 including the first groove segment 12011 and the second groove segment 12012 may alternatively be formed on the main board body 122. Correspondingly, the connection protrusion 1202 including the connection portion 12021 and the limiting portion 12022 is formed on the lower bracket 121. In the connection groove 1201 on the main board body 122, the second groove segment 12012 is located on a side of the first groove segment 12011 that faces away from the lower bracket 121, and the cross-sectional area of the second groove segment 12012 is larger than the cross-sectional area of the first groove segment 12011. In the connection protrusion 1202 on the lower bracket 121, one end of the connection portion 12021 is connected to a side surface of the lower bracket 121 that faces the main board body 122, and the limiting portion 12022 is connected to one end of the connection portion 12021 that is far away from the lower bracket 121. Details are not described herein again.

In some other implementations, each lower bracket 121 and the main board body 122 may be alternatively formed separately, and then each lower bracket 121 and the main board body 122 are welded together by using a welding process, for example, a laser welding process or a brazing process, to form the integrally connected lower shaft board 120. Because there is no connection gap between the main board body 122 and the lower bracket 121, and there is no interface of another material such as an adhesive layer, the lower shaft board 120 is equivalent to an integral structural member.

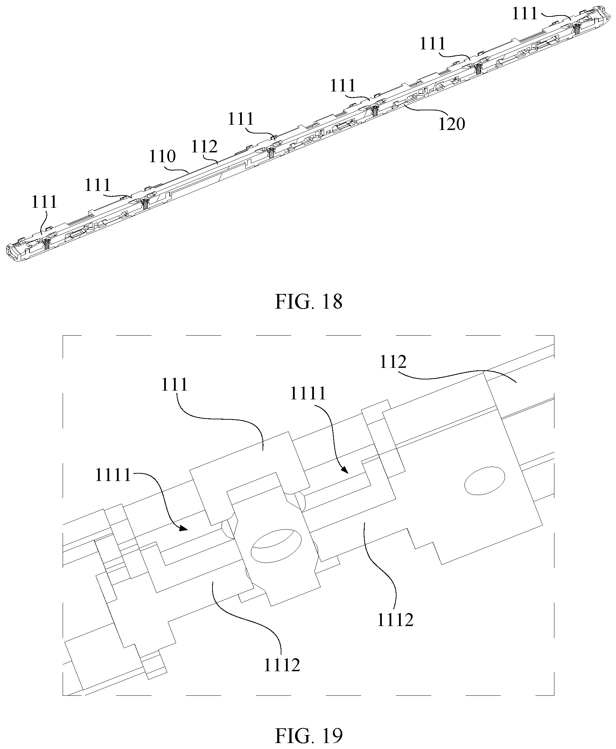

FIG. 18 is a half-sectional view of a main shaft according to an embodiment of this application. FIG. 18 shows a half-sectional state of the main shaft 100 along a width direction of the main shaft 100. It can be learned from the figure that, in the main shaft 100 of the rotary shaft mechanism 30, except a part provided with the structures such as the groove and the hole and a part through which a (through-shaft) flexible circuit board needs to pass, the upper shaft board 110 and the lower shaft board 120 are tightly attached to each other at other parts of a strong force-bearing region. The strong force-bearing region herein may refer to a region in which the foregoing functional components such as the movable assembly 200 and the damping synchronization structure 300 are located. In other words, the upper bracket 111 of the upper shaft board 110 and the lower bracket 121 of the lower shaft board 120 are tightly attached to each other. Certainly, based on this, the upper shaft board 110 and the lower shaft board 120 may also be tightly attached to each other in other regions.

In this way, the upper shaft board 110 and the lower shaft board 120 can transfer an external force to each other, especially in the strong force-bearing region of the main shaft 100, so that structural strength and reliability of the main shaft 100 can be ensured. In a moving process of the rotary shaft machine, the main shaft 100 can better resist an external force, and the main shaft 100 can be prevented from being deformed, to prolong a service life of the rotary shaft mechanism 30 and improve moving precision of the rotary shaft mechanism 30.

Based on this, to enhance the structural strength of the main shaft 100, in some implementations, the main shaft 100 may further be provided with at least one strengthening portion 123. The strengthening portion 123 may be connected to one of the upper shaft board 110 and the lower shaft board 120, and the strengthening portion 123 may protrude on a surface of one of the upper shaft board 110 or the lower shaft board 120 that faces the other (refer to FIG. 6 or FIG. 7). For example, the strengthening portion 123 may be connected to a side surface of the lower shaft board 120 that faces the upper shaft board 110, and the strengthening portion 123 protrudes toward the upper shaft board 110. Alternatively, the strengthening portion 123 may be connected to a side surface of the upper shaft board 110 that faces the lower shaft board 120, and the strengthening portion 123 protrudes toward the lower shaft board 120.

The at least one strengthening portion 123 is disposed on the main shaft 100, so that the strengthening portion 123 can improve the structural strength of the main shaft 100 and improve the reliability of the main shaft 100. In addition, using a position of the strengthening portion 123 as a reference, an arm for transmitting the external force is formed on two sides of the strengthening portion 123, so that an arm length of the main shaft 100 when the main shaft 100 transmits the external force can be reduced. Therefore, deformation, such as arching, recessing, or warping, of the main shaft 100 can be prevented, force-bearing stability of the main shaft 100 is enhanced, and moving precision of the rotary shaft mechanism 30 is improved.

For example, one strengthening portion 123 may be disposed in a middle region of the main shaft 100 in the length direction. Alternatively, a plurality of strengthening portions 123 may be arranged spaced away along the length direction of the main shaft 100. For example, the strengthening portion 123 may be disposed corresponding to the foregoing damping synchronization structure 300, and one strengthening portion 123 may be disposed at a position of each damping synchronization structure 300. In this case, the strengthening portion 123 may be located in a middle region of the damping synchronization structure 300, and the strengthening portion 123 can limit a position of the damping synchronization structure 300, to ensure mounting precision of the damping synchronization structure 300, and also prevent warping and deformation of a component in the damping synchronization structure 300.

The strengthening portion 123 may be integrally formed on the upper shaft board 110 or the lower shaft board 120, or the strengthening portion 123 may be connected to the upper shaft board 110 or the lower shaft board 120 through welding, adhesion, or locking. For example, the strengthening portion 123 may be locked om the lower shaft board 120 by using a screw.

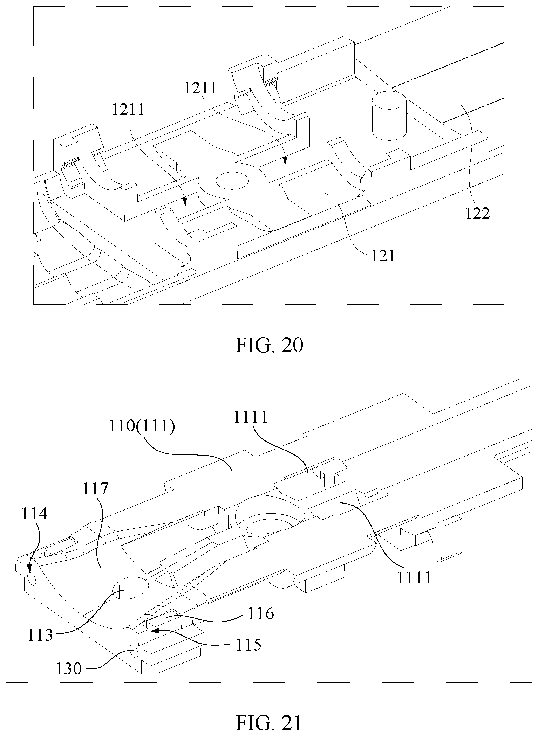

FIG. 19 is a partial enlarged view of a structure of a part A in FIG. 9. FIG. 20 is a partial enlarged view of a structure of a part B in FIG. 10. With reference to FIG. 19 and FIG. 20, to improve the structural strength of the entire main shaft 100, in some implementations, the upper shaft board 110 may further be provided with a reinforcement portion 1112, and the reinforcement portion 1112 may be specifically disposed on the upper bracket 111 of the upper shaft board 110. The reinforcement portion 1112 may be located between oppositely provided openings 1111 on the upper bracket 111 along a width direction of the upper shaft board 110, and the reinforcement portion 1112 protrudes toward the lower bracket 121. Correspondingly, the lower shaft board 120 may further be provided with a reinforcement groove 1211, and the reinforcement groove 1211 may be specifically disposed on the lower bracket 121 of the lower shaft board 120. The reinforcement groove 1211 of the lower bracket 121 corresponds to the reinforcement portion 1112 of the upper bracket 111, and the reinforcement groove 1211 may be located in a middle region of the lower bracket 121 in the width direction. The reinforcement portion 1112 of the upper shaft board 110 extends into the reinforcement groove 1211 of the lower shaft board 120.

It should be noted that the oppositely provided openings 1111 on the upper bracket 111 herein may be slot openings of grooves provided on two sides on the upper bracket 111. The grooves on the two sides are configured to mount functional components on two sides of the main shaft 100. For example, the grooves on the two sides are configured to mount the primary swing arm 210 or the secondary swing arm 220 on the two sides of the main shaft 100. The opposite openings 1111 are provided on the upper bracket 111, to mount the functional components on the two sides of the main shaft 100 into the grooves of the main shaft 100, and provide sufficient moving space for the functional components.

The reinforcement portion 1112 is disposed between the oppositely provided openings 1111 on the upper shaft board 110, to increase a thickness of the upper shaft board 110 at the reinforcement portion 1112, enhance structural strength of the upper shaft board 110 at the reinforcement portion 1112, and compensate for strength loss caused by the openings 1111. Further, the structural strength of the entire upper shaft board 110 can be enhanced, and the stability and the reliability of the upper shaft board 110 can be ensured. In addition, the reinforcement portion 1112 protrudes on the side surface of the upper shaft board 110 that faces the lower shaft board 120, so that the reinforcement portion 1112 does not affect flatness of a side surface of the upper shaft board 110 that faces the foldable screen 1a, and it can be ensured that the main shaft 100 stably supports the foldable screen 1a.

An overall thickness of the lower shaft board 120 is sufficient, and the lower bracket 121 does not have an opening portion. Therefore, when the reinforcement groove 1211 is provided on the lower bracket 121, an impact on the structural strength of the lower bracket 121 is not large, and an impact on the structural strength of the entire lower shaft board 120 may even be ignored.

Therefore, the reinforcement portion 1112 protruding toward the lower shaft board 120 is disposed on the upper shaft board 110, and the reinforcement groove 1211 is provided on a portion corresponding to the reinforcement portion 1112 on the lower shaft board 120, and the upper shaft board 110 and the lower shaft board 120 fit each other, so that the structural strength of the entire main shaft 100 can be enhanced, and the stability and the reliability of the main shaft 100 can be improved.

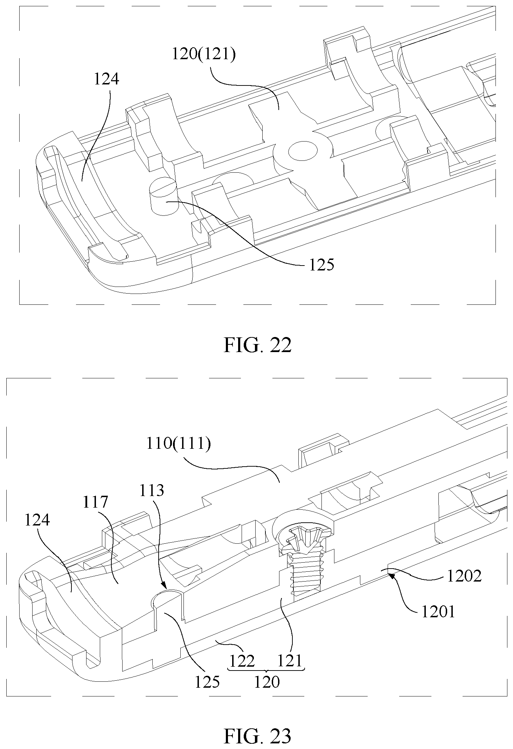

FIG. 21 is a diagram of a partial structure of an end portion of an upper shaft board according to an embodiment of this application. FIG. 22 is a diagram of a partial structure of an end portion of a lower shaft board according to an embodiment of this application. FIG. 23 is a partial cross-sectional view of an end portion of a main shaft according to an embodiment of this application.

Refer to FIG. 21 to FIG. 23, for positioning and fitting between the upper shaft board 110 and the lower shaft board 120, in this embodiment, a stop portion 124 may be disposed on each of two ends of the lower shaft board 120 in the length direction, and the stop portion 124 protrudes on the side surface of the lower shaft board 120 that faces the upper shaft board 110. A length of the upper shaft board 110 may be slightly shorter than a length of the lower shaft board 120, and the length of the upper shaft board 110 matches a distance between the stop portions 124 at the two ends of the lower shaft board 120. When the upper shaft board 110 and the lower shaft board 120 are assembled, the upper shaft board 110 is clipped into space between the stop portions 124 at the two ends of the lower shaft board 120. For example, two ends of the upper shaft board 110 abut against side walls of the stop portions 124 at the two ends of the lower shaft board 120, to basically position the upper shaft board 110.

In addition, refer to FIG. 21 and FIG. 22, to ensure assembly precision of the upper shaft board 110 and the lower shaft board 120, the upper shaft board 110 and the lower shaft board 120 may further be provided with positioning structures that fit each other. The positioning structures may include a positioning post 125 and a positioning hole 113 that fit each other. One of the upper shaft board 110 and the lower shaft board 120 is provided with the positioning post 125, and the other is provided with the positioning hole 113. The positioning hole 113 is in one-to-one correspondence with the positioning post 125. Refer to FIG. 23, when the upper shaft board 110 is connected to the lower shaft board 120, the positioning post 125 is inserted into the positioning hole 113, to implement fitting and positioning between the upper shaft board 110 and the lower shaft board 120.

Using an example in which the rotary shaft mechanism 30 is used in an inward-foldable electronic device, the side surface of the lower shaft board 120 that faces away from the upper shaft board 110 is exposed out of the electronic device. To avoid an impact on an appearance of the electronic device, the positioning hole 113 may be provided on the upper shaft board 110, and the positioning post 125 is provided on the lower shaft board 120. In this way, when the main shaft 100 is assembled, the lower shaft board 120 is used as a positioning basis, and it is also convenient to position the upper shaft board 110 on the lower shaft board 120.

Certainly, when the rotary shaft mechanism 30 is used in an outward-foldable electronic device, the positioning hole 113 may alternatively be provided on the lower shaft board 120, and the positioning post 125 may be provided on the upper shaft board 110. This is not limited in this embodiment. Descriptions are provided below by using an example in which the positioning hole 113 is provided on the upper shaft board 110 and the positioning post 125 is provided on the lower shaft board 120.

In comparison with a manner in which the upper brackets 111 are respectively abutted on and positioned with the lower shaft board 120, when the integrated upper shaft board 110 and the integrated lower shaft board 120 are directly fitted and positioned, fitting between the upper shaft board 110 and the lower shaft board 120 is simple and positioning precision is high, so that moving precision of the foregoing functional components can be improved, the problem that the foldable screen 1a arches can be improved, and use performance of the electronic device can be improved.

Because both the lower shaft board 120 and the upper shaft board 110 extend to the two ends of the main shaft 100 in the length direction, the upper shaft board 110 and the lower shaft board 120 may be fitted and positioned at the two ends of the main shaft 100. In other words, the positioning structures are disposed close to the two ends of the main shaft 100 in the length direction (refer to FIG. 6 or FIG. 7). In this way, there are fewer positioning structures on the main shaft 100, and there are fewer parts that need to be fitted and positioned on the upper shaft board 110 and the lower shaft board 120, thereby facilitating positioning between the upper shaft board 110 and the lower shaft board 120. In addition, when the two ends of the main shaft 100 are positioned, a distance between the two positioning structures on the main shaft 100 is large, so that positioning precision of the main shaft 100 can be improved. In addition, the positioning structures at the two ends of the main shaft 100 may be mutually symmetrical, thereby facilitating force-bearing balance of the main shaft 100.

For example, with reference to FIG. 21 and FIG. 22, the two ends of the upper shaft board 110 in the length direction may be provided with the positioning holes 113, and the two ends of the lower shaft board 120 in the length direction may be provided with the positioning posts 125. Refer to FIG. 23, when the upper shaft board 110 is connected to the lower shaft board 120, the positioning posts 125 at the two ends of the lower shaft board 120 are inserted into the positioning holes 113 at the two ends of the upper shaft board 110. Displacement of the positioning posts 125 of the lower shaft board 120 is limited by the positioning holes 113 of the upper shaft board 110, thereby implementing positioning of the upper shaft board 110 and the lower shaft board 120.

The positioning holes 113 may be provided on a center line of the upper shaft board 110, and correspondingly, the positioning posts 125 may be provided on a center line of the lower shaft board 120. For the positioning structures located at the two ends of the main shaft 100 in the length direction, the center line of the upper shaft board 110 herein may be a center line of the upper shaft board 110 in the width direction. Similarly, the center line of the lower shaft board 120 herein may be a center line of the lower shaft board 120 in the width direction. In this way, only one group of positioning structures fitting each other needs to be disposed at the two ends of the main shaft 100 in the length direction, so that it is more convenient to assemble the main shaft 100. In addition, because the positioning structures are located on the center line of the main shaft 100 in the width direction, distances between the positioning structures and the two ends of the main shaft 100 in the width direction are equivalent, thereby facilitating improving the positioning precision of the main shaft 100, so that the main shaft 100 is more stable and reliable.

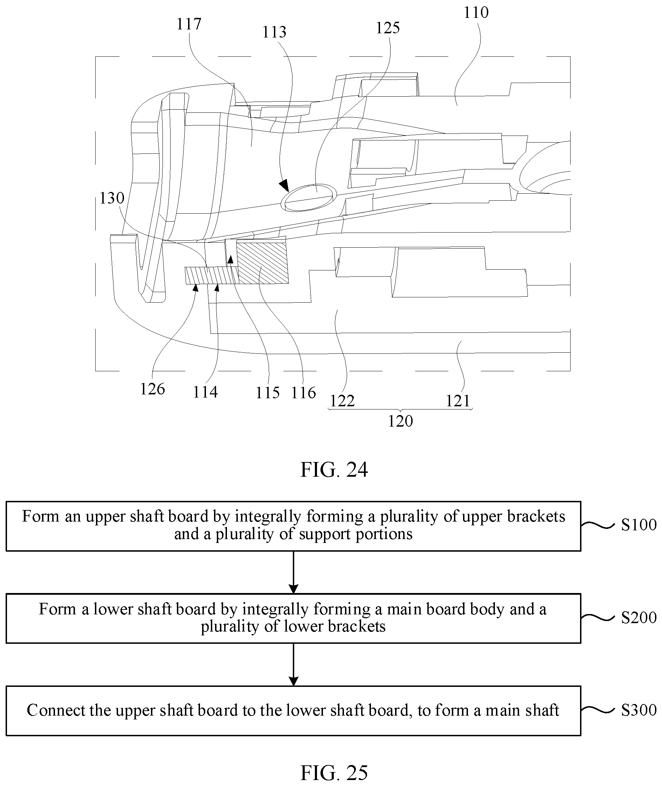

FIG. 24 is another cross-sectional view of an end portion of a main shaft according to an embodiment of this application. With reference to FIG. 21 and FIG. 24, for connection between the upper shaft board 110 and the lower shaft board 120, because the upper shaft board 110 and the lower shaft board 120 each are the integral structural member, two ends of the upper shaft board 110 and two ends of the lower shaft board 120 may be connected, to basically position and connect the upper shaft board 110 and the lower shaft board 120.

Specifically, a first pin hole 114 is provided at each of the two ends of the upper shaft board 110 in the length direction, and a second pin hole 126 is provided at each of the two ends of the lower shaft board 120 in the length direction. The first pin hole 114 corresponds to and communicates with the second pin hole 126. In addition, a positioning pin 130 is disposed, and the positioning pin 130 penetrates through the first pin hole 114 of the upper shaft board 110 and the second pin hole 126 of the lower shaft board 120, to connect the two ends of the upper shaft board 110 and the two ends of the lower shaft board 120 together, thereby implementing basic connection between the upper shaft board 110 and the lower shaft board 120.

The second pin hole 126 may be located at the stop portion 124 at an end portion of the lower shaft board 120, and the second pin hole 126 and the first pin hole 114 are located in a same plane along the thickness direction of the main shaft 100. Therefore, the positioning pin 130 can successively penetrate through the first pin hole 114 of the upper shaft board 110 and the second pin hole 126 of the lower shaft board 120. Relative positions of the upper shaft board 110 and the lower shaft board 120 may be limited by mutual limitation among the first pin hole 114 of the upper shaft board 110, the second pin hole 126 of the lower shaft board 120, and the positioning pin 130, to implement positioning of the upper shaft board 110 and the lower shaft board 120.

In this embodiment, through mutual fitting of the positioning hole 113 of the upper shaft board 110 and the positioning post 125 of the lower shaft board 120, the upper shaft board 110 and the lower shaft board 120 can be positioned in a plane direction of the main shaft 100, and the first pin hole 114 of the upper shaft board 110 can be aligned with the second pin hole 126 of the lower shaft board 120. Through fitting of the first pin hole 114 of the upper shaft board 110, the second pin hole 126 of the lower shaft board 120, and the positioning pin 130, the upper shaft board 110 and the lower shaft board 120 can be positioned in the thickness direction of the main shaft 100, and the upper shaft board 110 is further aligned with the lower shaft board 120 in the plane direction of the main shaft 100. In this way, double positioning in different directions may be performed on the upper shaft board 110 and the lower shaft board 120, to improve the positioning precision of the main shaft 100, improve the precision of the moving track of the rotary shaft mechanism 30, and improve the use performance of the electronic device.

In addition, a diameter of the first pin hole 114 of the upper shaft board 110 and a diameter of the second pin hole 126 of the lower shaft board 120 may both be small, a perforation volume of the upper shaft board 110 at a position of the first pin hole 114 is small, and a perforation volume of the lower shaft board 120 at a position of the second pin hole 126 is small. Based on that reliability of the upper shaft board 110 and the lower shaft board 120 is satisfied, a thickness of the upper shaft board 110 and a thickness of the lower shaft board 120 can be reduced, thereby facilitating lightening and thinning of the main shaft 100. In addition, to match the first pin hole 114 of the upper shaft board 110 and the second pin hole 126 of the lower shaft board 120, a diameter of the positioning pin 130 may be small. Space occupied by the positioning pin 130 is small, to facilitate structural designing of the two ends of the main shaft 100, thereby further improving the reliability of the main shaft 100.

Refer to FIG. 21 and FIG. 24, when the stop portions 124 disposed at the two ends of the lower shaft board 120 are only configured to limit movement of the upper shaft board 110 in the length direction of the main shaft 100, for example, when the stop portions 124 at the two ends of the lower shaft board 120 abut against only end surfaces at the two ends of the upper shaft board 110, the first pin hole 114 of the upper shaft board 110 and the second pin hole 126 of the lower shaft board 120 entirely extend approximately along the length direction of the main shaft 100. In this case, the first pin hole 114 of the upper shaft board 110 may extend along the length direction of the upper shaft board 110, the second pin hole 126 of the lower shaft board 120 may extend along the length direction of the lower shaft board 120, and the first pin hole 114 and the second pin hole 126 penetrating through each other extend along the length direction of the main shaft 100. When the upper shaft board 110 and the lower shaft board 120 are assembled, the positioning pin 130 may move along the length direction of the main shaft 100, and is inserted into the first pin hole 114 of the upper shaft board 110 and the second pin hole 126 of the lower shaft board 120.

The first pin hole 114 of the upper shaft board 110 and the second pin hole 126 of the lower shaft board 120 extend along the length direction of the main shaft 100, and the positioning pin 130 inserted into the first pin hole 114 and the second pin hole 126 extends along the length direction of the main shaft 100. In this way, when an external force is applied to the main shaft 100, the main shaft 100 does not easily generate an action force in another direction (other than the length direction of the main shaft 100), thereby facilitating improving the stability and the reliability of the main shaft 100.

Still refer to FIG. 21 and FIG. 24, during actual application, the second pin hole 126 of the lower shaft board 120 may be a blind hole. The blind hole of the lower shaft board 120 may extend from the stop portion 124 toward a side surface of the upper shaft board 110 and toward an end surface of the end portion of the lower shaft board 120. In this way, the second pin hole 126 can be prevented from being exposed on an outer surface of the lower shaft board 120, to improve an appearance effect of the main shaft 100. In this case, the positioning pin 130 needs to be mounted from a side on which the first pin hole 114 of the upper shaft board 110 is located to a side on which the second pin hole 126 of the lower shaft board 120 is located. In other words, when the upper shaft board 110 and the lower shaft board 120 are assembled, the positioning pin 130 successively penetrates through the first pin hole 114 of the upper shaft board 110 and the second pin hole 126 of the lower shaft board 120.

In view of this, to smoothly mount the positioning pin 130, a mounting groove 115 may be provided on the upper shaft board 110, and the mounting groove 115 may serve as a mounting base of the positioning pin 130. Corresponding to the first pin hole 114 of the upper shaft board 110, the mounting groove 115 may be close to the two ends of the upper shaft board 110 in the length direction, and the mounting groove 115 communicates with the first pin hole 114, in other words, the first pin hole 114 communicates with a hole wall of the mounting groove 115. For example, the first pin hole 114 extends along the length direction of the upper shaft board 110. The mounting groove 115 may be located on a side of the first pin hole 114 that is far away from the second pin hole 126 of the lower shaft board 120. In addition, the mounting groove 115 is connected to the side surface of the upper shaft board 110 of the upper shaft board 110 that faces away from the lower shaft board 120.

When the positioning pin 130 is mounted, the positioning pin 130 may first extend into the mounting groove 115 of the upper shaft board 110, so that the positioning pin 130 is aligned with the first pin hole 114. Then, the positioning pin 130 successively penetrates through the first pin hole 114 of the upper shaft board 110 and the second pin hole 126 of the lower shaft board 120, to connect the upper shaft board 110 to the lower shaft board 120 and perform basic connection on the upper shaft board 110 and the lower shaft board 120.

Refer to FIG. 21 or FIG. 24, to fix the positioning pin 130 in the main shaft 100, thereby preventing the end portion of the upper shaft board 110 from being detached from the end portion of the lower shaft board 120 due to loosening of the positioning pin 130, in this embodiment, a fixing member 116 may further be disposed in the mounting groove 115. The fixing member 116 abuts between an end portion of the positioning pin 130 and the groove wall of the mounting groove 115. The fixing member 116 blocks the positioning pin 130, so that the positioning pin 130 can be prevented from falling off, thereby ensuring reliable connection between the end portion of the upper shaft board 110 and the end portion of the lower shaft board 120. For example, the fixing member 116 may be a flexible member such as a silicon member or a rubber member, so that the fixing member 116 has elastic compression performance, to ensure that the fixing member 116 can be successfully mounted between the end portion of the positioning pin 130 and an inner wall of the mounting groove 115, and the positioning pin 130 is firmly fixed depending on an elastic force of the fixing member 116.

In another embodiment, the positioning pin 130 may alternatively be directly connected to and fixed in the mounting groove 115. For example, the positioning pin 130 is connected to a bottom or a side wall of the mounting groove 115 through welding or adhesion, so that the positioning pin 130 is directly and fixedly connected to the groove wall of the mounting groove 115, thereby fixing the positioning pin 130, and also preventing the positioning pin 130 from being loosened.

Still refer to FIG. 21 and FIG. 24, in an implementation, two first pin holes 114 may be provided at each end of the upper shaft board 110, and the two first pin holes 114 may be respectively close to two sides of the upper shaft board 110 in the width direction. Correspondingly, two second pin holes 126 may be provided at each end of the lower shaft board 120, and the two second pin holes 126 may be respectively close to two sides of the lower shaft board 120 in the width direction. The positioning pin 130 is inserted into both the first pin hole 114 and the second pin hole 126 on the two sides of each end of the main shaft 100 in the width direction, and the two sides of each end of the main shaft 100 in the width direction are connected and positioned, so that connection strength between the end portion of the upper shaft board 110 and the end portion of the lower shaft board 120 can be improved, thereby improving the integrity and reliability of the main shaft 100. In addition, the first pin hole 114 and the second pin hole 126 are disposed close to the two sides of the main shaft 100 in the width direction, so that more space can be reserved at the two ends of the main shaft 100 in the length direction, to satisfy design requirements at the two ends of the main shaft 100 and improve performance of the rotary shaft mechanism 30.

The two first pin holes 114 at each end of the upper shaft board 110 in the length direction may be symmetrically arranged along the center line of the upper shaft board 110 in the width direction. Correspondingly, the two second pin holes 126 at each end of the lower shaft board 120 in the length direction may be symmetrically arranged along the center line of the lower shaft board 120 in the width direction. In this case, the two positioning pins 130 at each end of the main shaft 100 in the length direction are symmetrically arranged along the center line of the main shaft 100 in the width direction. In this way, structural symmetry of the two ends of the main shaft 100 is good, and forces borne by the main shaft 100 are balanced, so that the stability and the reliability of the main shaft 100 can be improved.

Still refer to FIG. 21 and FIG. 24, because the two positioning pins 130 at each end of the main shaft 100 are respectively disposed close to the two sides of the main shaft 100 in the width direction, and the end portions of the main shaft 100 have large space, in this embodiment, an avoidance groove 117 is provided at each of the two ends of the main shaft 100 in the length direction. The avoidance groove 117 may be located on a side of the main shaft 100 that faces the foldable screen 1a. Using an inner-folded electronic device as an example, the avoidance groove 117 may be disposed on the upper shaft board 110, and the avoidance groove 117 is recessed to a side on which the lower shaft board 120 is located.

The avoidance grooves 117 are provided at the two ends of the main shaft 100 in the length direction, so that the avoidance grooves 117 are located on a side on which the foldable screen 1a is located. In a normal situation, the foldable screen 1a is adhered to a surface of the main shaft 100, and there is a gap between the foldable screen 1a and a bottom of the avoidance groove 117. The gap forms protective space. When the electronic device has a risk such as collision or falling, the foldable screen 1a has deformation space at a position of the avoidance groove 117, to avoid hard collision between the foldable screen 1a and the main shaft 100, so that the foldable screen 1a can be prevented from being fragmented due to an external force. A deformed part of the foldable screen 1a is accommodated by using the avoidance groove 117, so that integrity of the foldable screen 1a can be protected, thereby improving collision reliability of the electronic device.

The avoidance grooves 117 at the two ends of the main shaft 100 may be arc-shaped grooves, and along the thickness direction of the main shaft 100, longitudinal sections of the avoidance grooves 117 are arc-shaped. In other words, a depth of the avoidance groove 117 gradually increases from the two sides of the main shaft 100 in the width direction to the center line of the main shaft 100 in the width direction. Through this setting, the depth of the avoidance groove 117 gradually changes, and no stress concentration part occurs, thereby facilitating improving the reliability of the main shaft 100. In addition, the avoidance groove 117 has a sufficient depth in a middle region of the main shaft 100 in the width direction to accommodate the deformed part of the foldable screen 1a, so that it can be ensured that the avoidance groove 117 can have an effective protective function.

In addition, in some implementations, a groove width of the avoidance groove 117 may gradually increase from a center of the main shaft 100 to the end portion of the main shaft 100 along the length direction of the main shaft 100. On one hand, a groove width of an end of the avoidance groove 117 that is far away from the end portion of the main shaft 100 is small. Therefore, the avoidance groove 117 has a small impact on structural designing of the upper bracket 111 close to the end portion of the main shaft 100, and does not affect the structures such as the groove and the hole on the upper bracket 111, to ensure structural strength of the upper bracket 111 and satisfy a design requirement of the upper bracket 111. On the other hand, being closer to the end portion of the main shaft 100 indicates a larger groove width of the avoidance groove 117 and more accommodating space of the avoidance groove 117, so that it can be ensured that the avoidance groove 117 is sufficient for accommodating the deformed part of the foldable screen 1a, to ensure a protective function of the avoidance groove 117.

For example, the avoidance groove 117 may be located, along the width direction of the main shaft 100, between the two first pin holes 114 located at the end portion of the upper shaft board 110. In other words, when the avoidance groove 117 is located at a position at which the groove width of the avoidance groove 117 is largest, for example, at one end of the avoidance groove 117 that is close to the end portion of the main shaft 100, two sides of the avoidance groove 117 are located between the two first pin holes 114. In this way, the avoidance groove 117 does not affect a board thickness of the upper shaft board 110 at the first pin holes 114, to ensure that the upper shaft board 110 has a sufficient thickness at the first pin holes 114, so that the structural strength and the reliability of the upper shaft board 110 are not affected.

Based on this, a plurality of locking members 140 (for example, screws or rivets) (refer to FIG. 6 or FIG. 7) may be arranged spaced away along the length direction of the main shaft 100, to lock the upper shaft board 110 and the lower shaft board 120 together, thereby ensuring that the upper shaft board 110 is firmly connected to the lower shaft board 120. Locking may be performed at least on positions at which the upper bracket 111 of the upper shaft board 110 and the lower bracket 121 of the lower shaft board 120 are located. In other words, the locking member 140 is disposed on each upper bracket 111 and each lower bracket 121. In this way, it can be ensured that the upper bracket 111 is tightly attached to the lower bracket 121, thereby ensuring the structural strength of the main shaft 100 in the strong force-bearing region, and ensuring that the main shaft 100 is not deformed by an external force.

When the locking member 140 connected between the upper shaft board 110 and the lower shaft board 120 is a screw, the upper shaft board 110 may be provided with a threaded hole penetrating through a thickness direction of the upper shaft board 110, and the lower shaft board 120 may be provided with a threaded blind hole communicating with a front surface (the side surface of the lower shaft board 120 that faces the upper shaft board 110) of the lower shaft board 120. In this way, it is ensured that the main shaft 100 has a sufficient thread depth, locking strength of the screw to the upper shaft board 110 and the lower shaft board 120 is ensured, and cracking of the main shaft 100 in a risk scenario such as collision or falling is avoided.

An embodiment of this application further provides a production method of a main shaft 100. The production method is used to produce the main shaft 100 in a rotary shaft mechanism 30 in this embodiment.

FIG. 25 is a flowchart of steps of a production method of a main shaft according to an embodiment of this application. Refer to FIG. 25, the production method provided in this embodiment includes the following steps.

S100: Form an upper shaft board by integrally forming a plurality of upper brackets and a plurality of support portions.

The upper shaft board 110 may be integrally formed by using the foregoing molding technology such as the amorphous metal molding technology, the metal powder injection molding technology, or the 3D printing technology. The upper shaft board 110 may be entirely made of a metal material. For example, the upper shaft board 110 is made of an alloy material such as titanium alloy or aluminum alloy.

The integrally formed upper shaft board 110 includes a plurality of upper brackets 111 and a plurality of support portions 112. The upper brackets 111 may be arranged spaced away along a length direction of the upper shaft board 110. The support portions 112 may be connected between adjacent ones of the upper brackets 111.

S200: Form a lower shaft board by integrally forming a main board body and a plurality of lower brackets.

In some implementations, the upper shaft board 110 may be integrally formed by using the foregoing molding technology such as the amorphous metal molding technology, the metal powder injection molding technology, or the 3D printing technology. The integrally formed lower shaft board 120 may include a main board body 122 and a plurality of lower brackets 121. The main board body 122 may extend to two ends of a main shaft 100 along a length direction of the main shaft 100. The lower brackets 121 may be arranged spaced away along a length direction of the main board body 122. The lower brackets 121 are all connected to the main board body 122. The lower shaft board 120 may be entirely made of a same metal material. For example, the lower shaft board 120 is made of an alloy material such as titanium alloy or aluminum alloy.

In some other implementations, one of the lower bracket 121 and the main board body 122 is first formed. Then, the first formed one of the lower bracket 121 and the main board body 122 is used as a basic structure, and the other of the lower bracket 121 and the main board body 122 is integrally formed on the first formed one, to form the lower shaft board 120. The lower bracket 121 and the main board body 122 may be made of different materials. For example, the lower bracket 121 and the main board body 122 each are produced by using a metal material, and a metal material of the lower bracket 121 and a metal material of the main board body 122 may be different.

One of the lower bracket 121 and the main board body 122 is formed first. When the other of the lower bracket 121 and the main board body 122 is formed on the first formed one, a connection groove 1201 may be formed on the first formed one of the lower bracket 121 and the main board body 122. In a forming process, a material of the later formed one of the lower bracket 121 and the main board body 122 enters the connection groove 1201, and a connection protrusion 1202 may be formed on the later formed one. The connection protrusion 1202 of the later formed one is integrally connected to the connection groove 1201 of the first formed one, to integrally connect the lower bracket 121 to the main board body 122.

In an implementation, the main board body 122 may be first formed, and the connection groove 1201 may be formed on the main board body 122. Then, each lower bracket 121 is formed on the main board body 122, and the material of the lower bracket 121 enters the connection groove 1201 on the main board body 122, to form a glue-pulling structure on the lower bracket 121. The glue-pulling structure is the connection protrusion 1202 that protrudes on a surface of the lower bracket 121. In another implementation, each lower bracket 121 may be first formed, and the connection groove 1201 may be formed on each lower bracket 121. Then, the main board body 122 is formed on each lower bracket 121, the material of the main board body 122 enters the connection groove 1201 of each lower bracket 121, to form a glue-pulling structure on the main board body 122. The glue-pulling structure is the connection protrusion 1202 that protrudes on a surface of the main board body 122.

A mold may be designed, and after the first formed one of the lower bracket 121 and the main board body 122 is formed, the connection groove 1201 is formed. Alternatively, the first formed one of the lower bracket 121 and the main board body 122 may not have the connection groove 1201. The connection groove 1201 is processed on the lower bracket 121 or the main board body 122 by using a CNC processing technology.

In another implementation, the lower bracket 121 and the main board body 122 may alternatively be separately formed first by using the foregoing molding technology such as the amorphous metal molding technology, the metal powder injection molding technology, or the 3D printing technology. Then, each lower bracket 121 and the main board body 122 are welded together by using a welding process, for example, a laser welding process or a brazing process, to form the integrally connected lower shaft board 120.

S300: Connect the upper shaft board to the lower shaft board, to form the main shaft.

After the integrated upper shaft board 110 and the integrated lower shaft board 120 are produced, the upper shaft board 110 and the lower shaft board 120 are connected together, to assemble the upper shaft board 110 and the lower shaft board 120 into the main shaft 100.

For example, when the upper shaft board 110 is connected to the lower shaft board 120, the lower shaft board 120 may be used as a basic, so that positioning posts 125 at two ends of the lower shaft board 120 in the length direction penetrate through positioning holes 113 at two ends of the upper shaft board 110 in the length direction. Then, a positioning pin 130 is successively inserted into a first pin hole 114 at an end portion of the upper shaft board 110 and a second pin hole 126 at an end portion of the lower shaft board 120. Finally, a locking member 140 (for example, a screw) is locked in a threaded hole of the upper shaft board 110 and a threaded blind hole of the lower shaft board 120, to firmly connect the upper shaft board 110 to the lower shaft board 120.

In the descriptions of the embodiments of this application, it should be noted that, unless otherwise explicitly stipulated and restricted, terms "mounting", "joint connection", and "connection" should be understood broadly, which, for example, may be a fixed connection, or may be an indirect connection by using a medium, or may be an internal communication between two components, or may be an interactive relationship between two components. For the ordinary person skilled in the art, the specific meanings of the foregoing terms in the embodiments of this application may be interpreted according to specific situations.

The terms such as "first", "second", "third", and "fourth" (if any) in the specification of the embodiments of this application, the claims, and the foregoing accompanying drawings are used to distinguish similar objects and not necessarily used to describe any particular order or sequence.

## Claims

1. A main shaft, comprising:
an upper shaft board, comprising a plurality of upper brackets and a plurality of support portions, wherein the plurality of upper brackets and the plurality of support portions are an integral structural member; and the upper brackets are arranged spaced away along a length direction of the upper shaft board, and the support portions are connected between adjacent ones of the upper brackets; and
a lower shaft board, connected to the upper shaft board, wherein the lower shaft board comprises a main board body and a plurality of lower brackets, and the plurality of lower brackets and the main board body are an integral structural member; and the lower brackets are arranged spaced away along a length direction of the main board body, and the lower brackets are in one-to-one correspondence with the upper brackets.

2. The main shaft according to claim 1, wherein one of the lower bracket and the main board body is provided with a connection groove, and the other is provided with a connection protrusion, the connection protrusion extends into the connection groove, and the connection protrusion is integrally connected to the connection groove.

3. The main shaft according to claim 2, wherein the connection groove is provided on the lower bracket, the connection groove comprises a first groove segment and a second groove segment, the second groove segment is located on a side of the first groove segment that faces away from the main board body, and a cross-sectional area of the second groove segment is larger than a cross-sectional area of the first groove segment; and
the connection protrusion is provided on the main board body, the connection protrusion comprises a connection portion and a limiting portion, and the limiting portion is connected to an end of the connection portion that is far away from the main board body; and the connection portion is integrally connected to the first groove segment, and the limiting portion is integrally connected to the second groove segment.

4. The main shaft according to any one of claims 1 to 3, wherein a first pin hole is provided at each of two ends of the upper shaft board in the length direction, a second pin hole is provided at each of two ends of the lower shaft board in a length direction, the first pin hole correspondingly communicates with the second pin hole, and a positioning pin is inserted into the first pin hole and the second pin hole.

5. The main shaft according to claim 4, wherein a mounting groove is provided on the upper shaft board, the mounting groove is close to the two ends of the upper shaft board in the length direction and corresponds to the first pin hole, and the first pin hole communicates with a groove wall of the mounting groove.

6. The main shaft according to claim 5, wherein a fixing member is disposed in the mounting groove, and the fixing member abuts between an end portion of the positioning pin and the groove wall of the mounting groove.

7. The main shaft according to claim 4, wherein the first pin hole extends along the length direction of the upper shaft board, and the second pin hole extends along the length direction of the lower shaft board.

8. The main shaft according to claim 4, wherein two first pin holes are provided at each end of the upper shaft board, and the two first pin holes are respectively close to two sides of the upper shaft board in a width direction; and
two second pin holes are provided at each end of the lower shaft board, and the two second pin holes are respectively close to two sides of the lower shaft board in a width direction.

9. The main shaft according to claim 8, wherein the two first pin holes at each end of the upper shaft board are symmetrically arranged along a center line of the upper shaft board; and
the two second pin holes at each end of the lower shaft board are symmetrically arranged along a center line of the lower shaft board.

10. The main shaft according to claim 9, wherein an avoidance groove is provided at each of two ends of the main shaft in a length direction, and the avoidance groove is located on a side on which a foldable screen is located.

11. The main shaft according to claim 10, wherein a groove width of the avoidance groove gradually increases from a center of the main shaft to an end portion of the main shaft along the length direction of the main shaft.

12. The main shaft according to claim 10, wherein the avoidance groove is located between the two second pin holes along a width direction of the main shaft.

13. The main shaft according to any one of claims 1 to 3, wherein one of the upper shaft board and the lower shaft board is provided with a positioning post, the other is provided with a positioning hole, and the positioning post is inserted into the positioning hole.

14. The main shaft according to claim 13, wherein the positioning post is provided close to each of two ends of one of the upper shaft board and the lower shaft board in the length direction, and the positioning hole is provided close to each of two ends of the other of the upper shaft board and the lower shaft board in the length direction.

15. The main shaft according to claim 14, wherein the positioning post is located on a center line of one of the upper shaft board and the lower shaft board, and the positioning hole is located on a center line of the other of the upper shaft board and the lower shaft board.

16. The main shaft according to any one of claims 1 to 3, wherein the upper brackets are tightly attached to the lower brackets.

17. The main shaft according to any one of claims 1 to 3, wherein the main shaft is provided with at least one strengthening portion, and the strengthening portion protrudes on a side surface of at least one of the upper shaft board and the lower shaft board that faces the other.

18. The main shaft according to any one of claims 1 to 3, wherein the upper bracket is provided with a reinforcement portion, the reinforcement portion is located between oppositely provided openings along a width direction of the upper shaft board, and the reinforcement portion protrudes toward the lower bracket; and
the lower bracket is provided with a reinforcement groove, the reinforcement groove corresponds to the reinforcement portion, and the reinforcement portion extends into the reinforcement groove.

19. A production method of a main shaft, wherein the production method is used to produce the main shaft according to any one of claims 1 to 18, and comprises:
forming an upper shaft board by integrally forming a plurality of upper brackets and a plurality of support portions;
forming a lower shaft board by integrally forming a main board body and a plurality of lower brackets; and
connecting the upper shaft board to the lower shaft board, to form the main shaft.

20. The production method of the main shaft according to claim 19, wherein the forming an upper shaft board or the forming a lower shaft board comprises:
integrally forming the upper shaft board or the lower shaft board by using an amorphous metal molding technology;
integrally forming the upper shaft board or the lower shaft board by using a metal powder injection molding technology; or
integrally forming the upper shaft board or the lower shaft board by using a 3D printing technology.

21. The production method of the main shaft according to claim 19, wherein the forming a lower shaft board comprises:
forming the main board body, wherein a connection groove is formed on the main board body; and
integrally forming each of the lower brackets on the main board body, to form a connection protrusion on each of the lower brackets, wherein the connection protrusion is integrally connected to the connection groove.

22. The production method of the main shaft according to claim 19, wherein the forming a lower shaft board comprises:
forming the lower brackets, wherein a connection groove is formed on each of the lower brackets; and
integrally forming the main board body on the lower brackets, to form a connection protrusion on the main board body, wherein the connection protrusion is integrally connected to the connection groove.

23. The production method of the main shaft according to claim 19, wherein the forming a lower shaft board comprises:
forming the main board body;
forming the lower brackets; and
welding the main board body to the lower brackets, to form the lower shaft board.

24. A rotary shaft mechanism, comprising:
the main shaft according to any one of claims 1 to 18;
connection frames, movably connected on two sides of the main shaft in a width direction; and
a movable assembly, movably connected between the main shaft and each of the connection frames.

25. An electronic device, comprising a first housing, a second housing, a foldable screen, and the rotary shaft mechanism according to claim 24, wherein
the first housing and the second housing are respectively connected on two sides of the rotary shaft mechanism, the foldable screen is mounted to the first housing and the second housing, and the foldable screen is supported by the rotary shaft mechanism.
